# EUROPEAN PATENT SPECIFICATION

(11) **EP 4 451 335 B1**
(45) Date of publication and mention of the grant of the patent: **01.04.2026**
(21) Application number: 22916250.8
(22) Date of filing: 08.07.2022
(51) Int. Cl.: H10H 20/819, H10H 20/857, H10D 86/60, H01L 25/16, H10D 86/00, H10D 86/40, H10H 29/80

(54) **DISPLAY DEVICE COMPRISING SEMICONDUCTOR LIGHT-EMITTING ELEMENT**
ANZEIGEVORRICHTUNG MIT LICHTEMITTIERENDEM HALBLEITERELEMENT
DISPOSITIF D'AFFICHAGE COMPRENANT UN ÉLÉMENT ÉLECTROLUMINESCENT À SEMI-CONDUCTEUR

(30) Priority: 27.12.2021 KR 20210188139
(43) Date of publication of application: 23.10.2024
(73) Proprietor: LG Electronics Inc., Yeongdeungpo-gu Seoul 07336 (KR); LG Display Co., Ltd., Seoul 07336 (KR)
(72) Inventor: KIM, Sunho, Seoul 06772 (KR); LEE, Youngwook, Paju-si Gyeonggi-do 10845 (KR); HONG, Gisang, Paju-si Gyeonggi-do 10845 (KR); LEE, Jongwon, Paju-si Gyeonggi-do 10845 (KR)
(74) Representative: Vossius & Partner Patentanwälte Rechtsanwälte mbB
(86) International application number: PCT/KR2022/009924
(87) International publication number: WO 2023/128095

(56) References cited:
- KR-A- 20190 067 524
- KR-A- 20190 121 274
- KR-A- 20200 021 966
- KR-A- 20200 026 683
- KR-A- 20200 088 949
- US-A1- 2021 280 746

## Description

### [Technical Field]

The embodiment relates to a display device, and more specifically, to a display device using a semiconductor light emitting device.

### [Background Art]

Display devices used in computer monitors, TVs, mobile phones, etc. include organic light emitting display devices (OLEDs) that emit light on their own, liquid crystal display devices (LCDs) that require a separate light source, and micro-LED displays.

Displays of the mentioned prior art are disclosed in KR 2020 0021966 A and KR 2019 0067524 A.

Micro-LED displays are displays that use micro-LEDs, semiconductor light emitting devices with a diameter or cross-sectional area of 100µm or less, as display elements.

Micro-LED displays use micro-LEDs, semiconductor light emitting devices, as display elements, so micro-led displays have excellent performance in many characteristics such as contrast ratio, response speed, color reproducibility, viewing angle, brightness, resolution, lifespan, luminous efficiency, and brightness.

In particular, micro-LED displays have the advantage of being able to freely adjust the size and resolution by separating and combining the screen in a modular manner, and the advantage of being able to implement a flexible display.

However, since large micro-LED displays require millions or more micro-LEDs, there is a technical problem that makes it difficult to quickly and accurately transfer micro-LEDs to the display panel. Meanwhile, there are methods for transferring semiconductor light emitting devices to a substrate, such as the pick and place process, the laser lift-off method, or the self-assembly method.

Among these, the self-assembly method is a method in which semiconductor light emitting devices find their assembly positions on their own in a fluid, and is advantageous for implementing large-screen display devices.

Meanwhile, when transferring light emitting devices in a fluid, there is a problem in which the assembly wiring is corroded by the fluid. Corrosion of the assembly wiring may cause electrical short-circuits and assembly defects.

In addition, when transferring a light emitting device to a substrate, there is a possibility that the light emitting device may be assembled at an angle which may cause problems with electrical connection with the wiring electrode. Therefore, it is necessary to ensure that the light emitting device is assembled in the correct position.

### [Disclosure]

### [Technical Problem]

The technical object of the embodiment is to provide a display device that precisely controls the spacing between assembly wirings.

In addition, the technical object of the embodiment is to provide a display device that may overcome the performance limitations of an exposure device and reduce the size of an opening in which a light emitting device is disposed.

In addition, the technical object of the embodiment is to provide a display device that may prevent the detachment of a light emitting device.

In addition, the technical object of the embodiment is to provide a display device that may improve the assembly power of a light emitting device.

The objects of the embodiment are not limited to the problems mentioned above, and include those that may be understood from the specification.

### [Technical Solution]

A display device including a semiconductor light emitting device according to an embodiment may include a substrate; first assembly wiring and second assembly wiring disposed spaced apart from each other on the substrate, each including a conductive layer and a clad layer on the conductive layer; a structure in contact with the second assembly wiring and having a reverse taper shape; a planarization layer disposed on the first assembly wiring and the second assembly wiring and having an opening; and a light emitting device disposed inside the opening, wherein a first electrode overlaps the first assembly wiring and the second assembly wiring, the structure is disposed to cover a portion of the upper surface of the conductive layer of the second assembly wiring, and the clad layer of the second assembly wiring may be disposed to cover the upper surface of the structure.

**In** addition, the embodiment may further include an insulating layer disposed between the first assembly wiring and the light emitting device, and the second assembly wiring may be exposed from the insulating layer at the opening.

The upper surface of the second assembly wiring may be disposed on the same plane as the upper surface of the insulating layer.

The conductive layer of the first assembly wiring and the conductive layer of the second assembly wiring may be disposed on the same layer, and the conductive layer of the first assembly wiring may be disposed on one side of the structure, and the conductive layer of the second assembly wiring may be disposed on the other side.

The clad layer of the second assembly wiring may contact a part of the side surface of the structure corresponding to the other side of the structure and the upper surface of the structure.

The clad layer of the first assembly wiring and the clad layer of the second assembly wiring may include the same material.

The cross-sectional area of the structure may decrease from the upper surface to the lower surface.

The area where the second assembly wiring and the opening overlap may be wider than the area where the first assembly wiring and the opening overlap.

The planarization layer may include a first planarization layer disposed to surround the side of the light emitting device and having a reverse tapered shape; a second planarization layer disposed on the first planarization layer to surround the side of the light emitting device and having a regular tapered shape; and a third planarization layer disposed on the second planarization layer to surround the side of the light emitting device and having a regular tapered shape.

An end of an upper surface of the first planarization layer may be in contact with an end of a lower surface of the second planarization layer, and an end of an upper surface of the second planarization layer may be in contact with an end of a lower surface of the third planarization layer.

An end of an upper surface of the first planarization layer may protrude toward the opening more than an end of a lower surface of the second planarization layer, and an end of an upper surface of the second planarization layer may protrude toward the opening more than an end of a lower surface of the third planarization layer.

The light emitting device may include a first electrode, a first semiconductor layer on the first electrode, a light emitting layer on the first semiconductor layer, a second semiconductor layer on the light emitting layer, and a second electrode on the second semiconductor layer, and the light emitting device may have a lower surface having a larger area than the upper surface.

The first electrode and the first semiconductor layer may have a larger area than the light emitting layer, the second semiconductor layer, and the second electrode.

An end of the first semiconductor layer may protrude outwardly from the side surfaces of the light emitting layer, the second semiconductor layer, and the second electrode.

The sum of the thicknesses of the first electrode and the first semiconductor layer may be smaller than the thickness of the first planarization layer.

In addition, a display device including a semiconductor light emitting device according to an embodiment may include a substrate;

A first assembly wiring and a second assembly wiring which are disposed spaced apart from each other on the substrate and each include a conductive layer and a clad layer; a structure in contact with the second assembly wiring and having a reverse taper shape; a planarization layer disposed on the first assembly wiring and the second assembly wiring and having an opening; and a light emitting device disposed inside the opening, wherein a first electrode overlaps the first assembly wiring and the second assembly wiring, and the planarization layer may include a first planarization layer disposed to surround a side of the light emitting device and having a reverse taper shape; a second planarization layer disposed on the first planarization layer to surround a side of the light emitting device and having a regular taper shape; and a third planarization layer disposed on the second planarization layer to surround a side of the light emitting device and having a regular taper shape, and the upper surface of the first planarization layer may protrude further inwardly from the opening than the lower surface of the first planarization layer.

In addition, in the embodiment, the clad layer of the second assembly wiring may be disposed on the upper surface of the structure having the reverse taper shape.

The conductive layer of the second assembly wiring may be disposed on the upper surface of the clad layer of the second assembly wiring.

The conductive layer of the second assembly wiring may be in contact with the lower surface of the light emitting device.

The first assembly wiring vertically overlaps the second assembly wiring.

The second assembly wiring may include an electrode hole in an area vertically overlapping the first assembly wiring and the light emitting device.

The clad layer of the second assembly wiring may be in contact with the lower surface of the light emitting device.

### [Advantageous Effects]

According to the embodiment, there is a technical effect that the wiring for self-assembly of the light emitting device may also be utilized as the wiring for driving the light emitting device.

In addition, the embodiment has a technical effect that the gap between a plurality of assembly wirings may be precisely controlled.

For example, there is a technical effect that the gap between a plurality of assembly wirings may be narrowed by arranging a structure having a reverse taper shape under the assembly wiring.

In addition, the embodiment has a technical effect that the size of the pocket in which the light emitting device is assembled may be minimized.

In addition, the embodiment has a technical effect that the shape of the planarization layer including the opening may be variously changed to improve the tilt defect during self-assembly of the light emitting device and prevent the phenomenon of the light emitting device being separated from the opening.

In addition, the embodiment has a technical effect of arranging multiple assembly wirings in a vertical symmetrical structure to enhance the assembly power of the light emitting device.

The technical effect of the embodiment is not limited to the contents exemplified above, and more diverse effects are included in the specification.

### [Description of Drawings]

FIG. 1 is a schematic plan view of a display device according to an embodiment.
FIG. 2 is a schematic enlarged plan view of a display device according to an embodiment.
FIG. 3 is a cross-sectional view according to III-III of FIG. 2.
FIGS. 4A to 4F are process diagrams for explaining a manufacturing method of a display device according to an embodiment.
FIG. 5 is a cross-sectional view of a display device according to a second embodiment.
FIG. 6 is a cross-sectional view of a display device according to a third embodiment.
FIG. 7 is a cross-sectional view of a display device according to a fourth embodiment.
FIG. 8 is a cross-sectional view of a display device according to a fifth embodiment.
FIG. 9 is a cross-sectional view of a display device according to a sixth embodiment.

### [Mode for Invention]

Hereinafter, the embodiments disclosed in this specification will be described in detail with reference to the attached drawings. The suffixes 'module' and 'part' used in the description below for components are given or used interchangeably in consideration of the ease of writing the specification, and do not have distinct meanings or roles in themselves. In addition, the attached drawings are intended to facilitate easy understanding of the embodiments disclosed in this specification, and the technical ideas disclosed in this specification are not limited by the attached drawings. In addition, when an element such as a layer, region, or substrate is mentioned as existing 'on' another element, this includes that it may be directly on the other element or that other intermediate elements may exist between them.

The display devices described in this specification may include digital TVs, mobile phones, smart phones, laptop computers, digital broadcasting terminals, PDAs (personal digital assistants), PMPs (portable multimedia players), navigation, slate PCs, tablet PCs, Ultra-Books, desktop computers, etc. However, the configuration according to the embodiment described in this specification may also be applied to a new product type developed in the future, or to a device capable of display.

Hereinafter, the embodiment will be described with reference to the drawings.

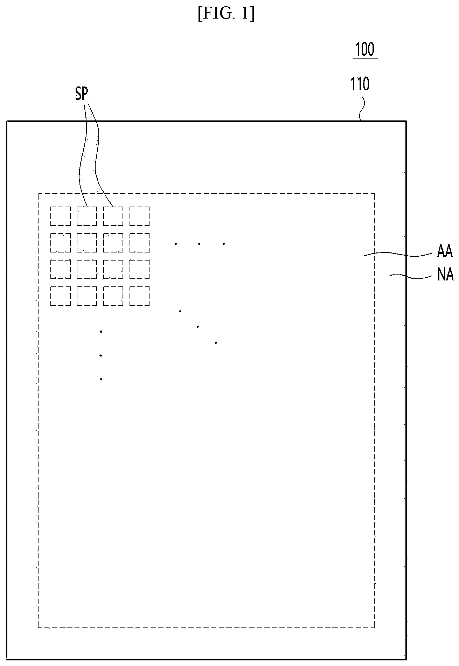

FIG. 1 is a schematic plan view of a display device according to an embodiment. In FIG. 1, for convenience of explanation, only the substrate 110 and the plurality of sub-pixels (SP) are shown among the various components of the display device 100.

The display device 100 according to the embodiment may include a flexible display manufactured on a thin and flexible substrate. The flexible display may be bent or rolled like paper while maintaining the characteristics of a conventional flat panel display.

In a flexible display, visual information may be implemented by independently controlling the light emission of unit pixels disposed in a matrix form. A unit pixel means a minimum unit for implementing one color. A unit pixel of a flexible display may be implemented by a light emitting device. In an embodiment, the light emitting device may be a Micro-LED or a Nano-LED, but is not limited thereto.

The substrate 110 is configured to support various components included in the display device 100, and may be made of an insulating material. For example, the substrate 110 may be made of glass or resin. Additionally, the substrate 110 may include polymer or plastic, or may be made of a material with flexibility.

The substrate 110 includes a display area (AA) and a non-display area (NA).

The display area (AA) is an area where multiple sub-pixels (SP) are disposed and an image is displayed. Each of the multiple sub-pixels (SP) is an individual unit that emits light, and a light emitting device (LED) and a driving circuit are formed in each of the multiple sub-pixels (SP). For example, the multiple sub-pixels (SP) may include a red sub-pixel, a green sub-pixel, a blue sub-pixel, and/or a white sub-pixel, but is not limited thereto. In the following description, it is assumed that the multiple sub-pixels (SP) include a red sub-pixel, a green sub-pixel, and a blue sub-pixel, but is not limited thereto.

The non-display area (NA) is an area where an image is not displayed, and is an area where various wiring, driving ICs, etc. for driving the sub-pixels (SP) disposed in the display area (AA) are disposed. For example, various ICs such as a gate driver IC and a data driver IC, and driving circuits, etc. may be disposed in the non-display area (NA). Meanwhile, the non-display area (NA) may be located on the back surface of the substrate 110, i.e., on a surface without sub-pixels (SP), or may be omitted, and is not limited to what is shown in the drawing.

The display device 100 of the embodiment may drive the light emitting device in an active matrix (AM) method or a passive matrix (PM) method.

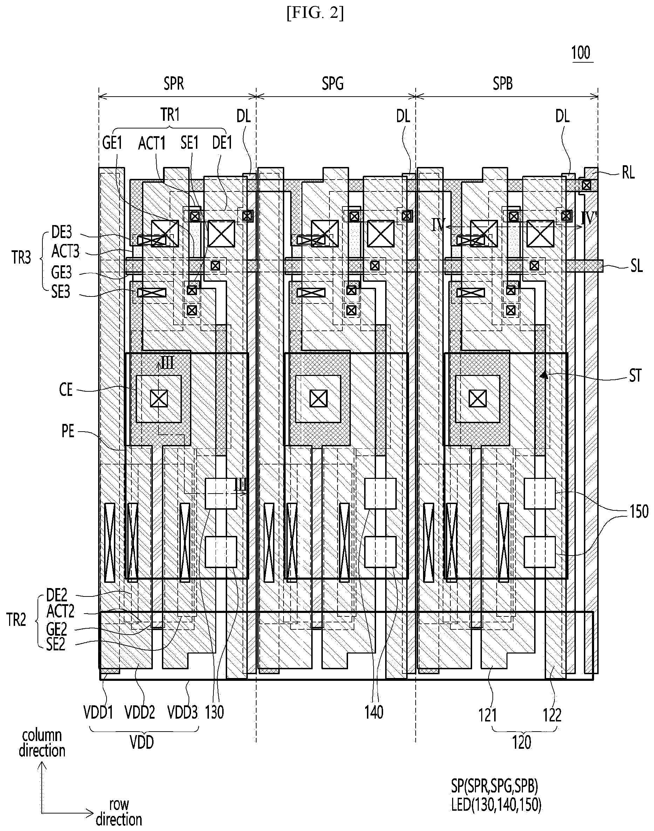

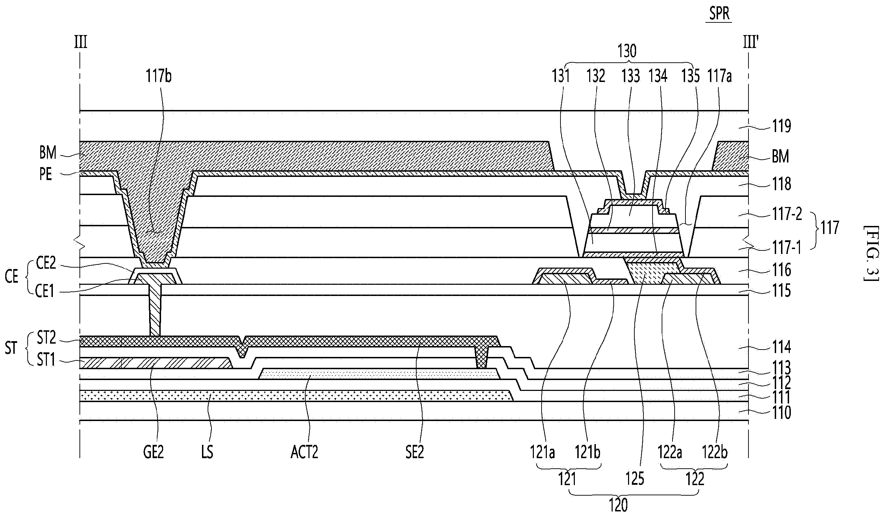

Hereinafter, for a more detailed description of the plurality of sub-pixels (SP), reference will be made to FIG. 2 and FIG. 3.

FIG. 2 is a schematic enlarged plan view of a display device according to an embodiment. FIG. 3 is a cross-sectional view along line III-III' of FIG. 2. Referring to FIGS. 2 and 3, the display device 100 according to the embodiment may include a plurality of scan lines (SL), a plurality of data lines (DL), a plurality of high-potential power lines (VDD), a plurality of assembly lines 120, a plurality of reference lines (RL), and a black matrix (BM) and each of a plurality of sub-pixels (SP), a first transistor (TR1), a second transistor (TR2), a third transistor (TR3), a storage capacitor (ST), a semiconductor light emitting device (LED), a light-shielding layer (LS), a buffer layer 111, a gate insulating layer 112, a plurality of passivation layers 113, 115, 116, a plurality of planarization layers 114, 117, 118, a connection electrode (CE), and a pixel electrode (PE), etc.

Referring to FIG. 2 and FIG. 3, a plurality of data lines (DL), a first layer (VDD1) and a second layer (VDD2) of high-potential power lines (VDD), a plurality of reference lines (RL) and a plurality of assembly lines 120 may extend in a column direction between a plurality of sub-pixels (SP), and a plurality of scan lines (SL) and a third layer (VDD3) of high-potential power lines (VDD) may extend in a row direction between a plurality of sub-pixels (SP). And a first transistor (TR1), a second transistor (TR2), a third transistor (TR3) and a storage capacitor (ST) may be disposed in each of the plurality of sub-pixels (SP).

First, a first layer (VDD1) of high-potential power lines (VDD) and a light-shielding layer (LS) may be disposed on a substrate 110.

The high-potential power wiring (VDD) is a wiring that transmits a high-potential power voltage to each of the plurality of sub-pixels (SP). The plurality of high-potential power wirings (VDD) may transmit the high-potential power voltage to the second transistor (TR2) of each of the plurality of sub-pixels (SP).

Meanwhile, the plurality of high-potential power wirings (VDD) may be formed of a single layer or multiple layers, and for convenience of explanation, it will be explained below assuming that the plurality of high-potential power wirings (VDD) are formed of multiple layers.

The high-potential power wiring (VDD) includes a plurality of first layers (VDD1), a plurality of second layers (VDD2), and a plurality of third layers (VDD3) connecting them. The first layer (VDD1) may extend in the column direction between each of the plurality of sub-pixels (SP).

A light-shielding layer (LS) may be disposed on each of the plurality of sub-pixels (SP) on the substrate 110. The light shielding layer (LS) may block light incident on the second active layer (ACT2) of the second transistor (TR2) described later from the lower portion of the substrate 110, thereby minimizing leakage current.

A buffer layer 111 may be disposed on the first layer (VDD1) of the high-potential power wiring (VDD) and the light-shielding layer (LS). The buffer layer 111 may reduce the penetration of moisture or impurities through the substrate 110. The buffer layer 111 may be composed of, for example, a single layer or multiple layers of silicon oxide (SiOx) or silicon nitride (SiNx), but is not limited thereto. However, the buffer layer 111 may be omitted depending on the type of the substrate 110 or the type of the transistor, and is not limited thereto.

A plurality of scan wirings (SL), a plurality of reference wirings (RL), a plurality of data wirings (DL), a first transistor (TR1), a second transistor (TR2), a third transistor (TR3), and a storage capacitor (ST) may be disposed on the buffer layer 111.

First, a first transistor (TR1) may be placed in each of the plurality of sub-pixels (SP). The first transistor (TR1) includes a first active layer (ACT1), a first gate electrode (GE1), a first source electrode (SE1), and a first drain electrode (DE1). The first active layer (ACT1) is placed on a buffer layer 111. The first active layer (ACT1) may be made of a semiconductor material such as an oxide semiconductor, amorphous silicon, or polysilicon, but is not limited thereto.

A gate insulating layer 112 may be placed on the first active layer (ACT1). The gate insulating layer 112 is an insulating layer for insulating the first active layer (ACT1) and the first gate electrode (GE1), and may be composed of a single layer or multiple layers of silicon oxide (SiOx) or silicon nitride (SiNx), but is not limited thereto.

The first gate electrode (GE1) may be placed on the gate insulating layer 112. The first gate electrode (GE1) may be electrically connected to the scan line (SL). The first gate electrode (GE1) may be composed of a conductive material, such as, but not limited to, copper (Cu), aluminum (Al), molybdenum (Mo), nickel (Ni), titanium (Ti), chromium (Cr), or an alloy thereof.

A first passivation layer 113 may be disposed on the first gate electrode (GE1). A contact hole is formed in the first passivation layer 113 for each of the first source electrode (SE1) and the first drain electrode (DE1) to connect to the first active layer (ACT1). The first passivation layer 113 is an insulating layer for protecting the configuration under the first passivation layer 113, and may be formed of a single layer or multiple layers of silicon oxide (SiOx) or silicon nitride (SiNx), but is not limited thereto.

A first source electrode (SE1) and a first drain electrode (DE1) electrically connected to the first active layer (ACT1) may be disposed on the first passivation layer 113. The first drain electrode (DE1) may be connected to the data line (DL), and the first source electrode (SE1) may be connected to the second gate electrode (GE2) of the second transistor (TR2). The first source electrode (SE1) and the first drain electrode (DE1) may be composed of a conductive material, for example, copper (Cu), aluminum (Al), molybdenum (Mo), nickel (Ni), titanium (Ti), chromium (Cr), or an alloy thereof, but are not limited thereto.

Meanwhile, in the embodiment, the first source electrode (SE1) and the first drain electrode (DE1) are described as being connected to the second gate electrode (GE2) and the data line (DL), but depending on the type of the transistor, the first source electrode (SE1) may be connected to the data line (DL), and the first drain electrode (DE1) may be connected to the second gate electrode (GE2) of the second transistor (TR2), but are not limited thereto.

The first transistor (TR1) has a first gate electrode (GE1) connected to a scan line (SL) and may be turned on or off according to a scan signal. The first transistor (TR1) may transmit a data voltage to the second gate electrode (GE2) of the second transistor (TR2) based on the scan signal and may be referred to as a switching transistor.

Meanwhile, a plurality of data lines (DL) and a plurality of reference lines (RL) may be disposed on the gate insulating layer 112 together with the first gate electrode (GE1). The plurality of data lines (DL) and the reference lines (RL) may be formed using the same material and the same process as the first gate electrode (GE1).

The plurality of data lines (DL) are lines that transmit a data voltage to each of the plurality of sub-pixels (SP). The plurality of data lines (DL) may transmit the data voltage to the first transistor (TR1) of each of the plurality of sub-pixels (SP). For example, the plurality of data wires (DL) may be composed of a data wire (DL) that transmits a data voltage to a red sub-pixel (SPR), a data wire (DL) that transmits a data voltage to a green sub-pixel (SPG), and a data wire (DL) that transmits a data voltage to a blue sub-pixel (SPB).

The plurality of reference wirings (RL) are wirings that transmit a reference voltage to each of the plurality of sub-pixels (SP). The plurality of reference wirings (RL) may transmit the reference voltage to the third transistor (TR3) of each of the plurality of sub-pixels (SP).

A second transistor (TR2) may be disposed in each of the plurality of sub-pixels (SP). The second transistor (TR2) may include a second active layer (ACT2), a second gate electrode (GE2), a second source electrode (SE2), and a second drain electrode (DE2). The second active layer (ACT2) may be disposed on the buffer layer 111. The second active layer (ACT2) may be made of a semiconductor material such as an oxide semiconductor, amorphous silicon, or polysilicon, but is not limited thereto.

A gate insulating layer 112 may be disposed on the second active layer (ACT2), and a second gate electrode (GE2) may be disposed on the gate insulating layer 112. The second gate electrode (GE2) may be electrically connected to the first source electrode (SE1) of the first transistor (TR1). The second gate electrode (GE2) may be composed of a conductive material, for example, copper (Cu), aluminum (Al), molybdenum (Mo), nickel (Ni), titanium (Ti), chromium (Cr), or an alloy thereof, but is not limited thereto.

A first passivation layer 113 may be disposed on the second gate electrode (GE2), and a second source electrode (SE2) and a second drain electrode (DE2) may be disposed on the first passivation layer 113. The second source electrode (SE2) is electrically connected to the second active layer (ACT2). The second drain electrode (DE2) is electrically connected to the second active layer (ACT2) and electrically connected to the high-potential power wiring (VDD). The second drain electrode (DE2) is disposed between the first layer (VDD1) and the second layer (VDD2) of the high-potential power wiring (VDD) and may be electrically connected to the high-potential power wiring (VDD).

The second transistor (TR2) may be turned on by a data voltage transmitted when the first transistor (TR1) is turned on, since the second gate electrode (GE2) is connected to the first source electrode (SE1) of the first transistor (TR1). In addition, the second transistor (TR2) that is turned on may transmit a driving current to a light emitting device (LED) based on a high-potential power voltage from a high-potential power line (VDD), and thus may be referred to as a driving transistor.

A third transistor (TR3) may be disposed in each of a plurality of sub-pixels (SP). The third transistor (TR3) includes a third active layer (ACT3), a third gate electrode (GE3), a third source electrode (SE3), and a third drain electrode (DE3). The third active layer (ACT3) may be disposed on a buffer layer 111. The third active layer (ACT3) may be made of a semiconductor material such as an oxide semiconductor, amorphous silicon, or polysilicon, but is not limited thereto.

A gate insulating layer 112 may be disposed on a third active layer (ACT3), and a third gate electrode (GE3) may be disposed on the gate insulating layer 112. The third gate electrode (GE3) may be connected to a scan line (SL), and the third transistor (TR3) may be turned on or off by a scan signal. The third gate electrode (GE3) may be composed of a conductive material, for example, copper (Cu), aluminum (Al), molybdenum (Mo), nickel (Ni), titanium (Ti), chromium (Cr), or an alloy thereof, but is not limited thereto.

However, although the third gate electrode (GE3) and the first gate electrode (GE1) are described as being connected to the same scan line (SL), the third gate electrode (GE3) may be connected to a different scan line (SL) from the first gate electrode (GE1), and is not limited thereto.

The first passivation layer 113 may be disposed on the third gate electrode (GE3), and the third source electrode (SE3) and the third drain electrode (DE3) may be disposed on the first passivation layer 113. The third source electrode (SE3) may be formed integrally with the second source electrode (SE2), and may be electrically connected to the third active layer (ACT3) and electrically connected to the second source electrode (SE2) of the second transistor (TR2). In addition, the third drain electrode (DE3) may be electrically connected to the reference wiring (RL).

The third transistor (TR3) electrically connected to the second source electrode (SE2), the reference wiring (RL), and the storage capacitor (ST) of the second transistor (TR2) which is a driving transistor, may be referred to as a sensing transistor.

The storage capacitor (ST) may be disposed on each of the plurality of sub-pixels (SP). The storage capacitor (ST) may include a first capacitor electrode (ST1) and a second capacitor electrode (ST2). The storage capacitor (ST) is connected between the second gate electrode (GE2) and the second source electrode (SE2) of the second transistor (TR2), and may store a voltage to maintain a constant voltage level of the gate electrode of the second transistor (TR2) while the light emitting device (LED) emits light.

The first capacitor electrode (ST1) may be formed integrally with the second gate electrode (GE2) of the second transistor (TR2). Accordingly, the first capacitor electrode (ST1) may be electrically connected to the second gate electrode (GE2) of the second transistor (TR2) and the first source electrode (SE1) of the first transistor (TR1).

The second capacitor electrode (ST2) may be disposed on the first capacitor electrode (ST1) with the first passivation layer 113 interposed therebetween. The second capacitor electrode (ST2) may be formed integrally with the second source electrode (SE2) of the second transistor (TR2) and the third source electrode (SE3) of the third transistor (TR3). Accordingly, the second capacitor electrode (ST2) may be electrically connected to the second transistor (TR2) and the third transistor (TR3).

Meanwhile, a plurality of scan lines (SL) may be disposed on the first passivation layer 113 together with the first source electrode (SE1), the first drain electrode (DE1), the second source electrode (SE2), the second drain electrode (DE2), the third source electrode (SE3), the third drain electrode (DE3), and the second capacitor electrode (ST2).

The plurality of scan lines (SL) are lines that transmit scan signals to each of the plurality of sub-pixels (SP). The plurality of scan lines (SL) may transmit scan signals to the first transistor (TR1) of each of the plurality of sub-pixels (SP). For example, each of the plurality of scan lines (SL) extends in the row direction and may transmit scan signals to the plurality of sub-pixels (SP) disposed in the same row.

Next, a lower planarization layer 114 is disposed on the plurality of scan lines (SL), the plurality of reference lines (RL), the plurality of data lines (DL), the first transistor (TR1), the second transistor (TR2), the third transistor (TR3), and the storage capacitor (ST). The lower planarization layer 114 may planarize the upper portion of the substrate 110 on which the plurality of transistors are disposed. The lower planarization layer 114 may be composed of a single layer or multiple layers, and may be made of, for example, an acrylic-based organic material, but is not limited thereto.

A second passivation layer 115 may be disposed on the lower planarization layer 114. The second passivation layer 115 is an insulating layer for protecting the configuration under the second passivation layer 115 and improving the adhesion of the configuration formed on the second passivation layer 115, and may be composed of a single layer or multiple layers of silicon oxide (SiOx) or silicon nitride (SiNx), but is not limited thereto.

A second layer (VDD2) of a high-potential power wiring (VDD), a plurality of assembly wirings 120, and a connection electrode (CE) may be disposed on the second passivation layer 115.

First, the plurality of assembly wirings 120 are wirings that generate an electric field for aligning the plurality of light emitting devices (LEDs) when manufacturing the display device 100 and supply a low-potential power voltage to the plurality of light emitting devices (LEDs) when driving the display device 100. Accordingly, the assembly wirings 120 may be referred to as low-potential power wires. The plurality of assembly wirings 120 may be disposed in a column direction along the plurality of sub-pixels (SP) disposed in the same line. The plurality of assembly wirings 120 may be disposed to overlap the plurality of sub-pixels (SP) disposed in the same column. For example, one first assembly wiring 121 and one second assembly wiring 122 may be disposed in a red sub-pixel (SPR) disposed in the same column. A first assembly wiring 121 and a second assembly wiring 122 may be disposed in a green sub-pixel (SPG), and a first assembly wiring 121 and a second assembly wiring 122 may be disposed in a blue sub-pixel (SPB).

The plurality of assembly wirings 120 may include a plurality of first assembly wirings 121 and a plurality of second assembly wirings 122. When the display device 100 is driven, the same low-potential voltage may be applied as an alternating current to the plurality of first assembly wirings 121 and the plurality of second assembly wirings 122. The plurality of first assembly wirings 121 and the plurality of second assembly wirings 122 may be disposed to be spaced apart from each other. In addition, in each of the plurality of sub-pixels (SP), one first assembly wiring 121 and one second assembly wiring 122 may be disposed adjacent to each other.

The plurality of first assembly wirings 121 and the plurality of second assembly wirings 122 may include a conductive material, for example, a material selected from the group consisting of copper (Cu), molybdenum (Mo), titanium (Ti), chromium (Cr), and combinations thereof, but are not limited thereto.

The plurality of first assembly wirings 121 include a first conductive layer 121a and a first clad layer 121b. The first conductive layer 121a may be disposed on the second passivation layer 115. The first clad layer 121b may be in contact with the first conductive layer 121a. For example, the first clad layer 121b may be disposed to cover the upper surface and side surfaces of the first conductive layer 121a. And the first conductive layer 121a may have a thickness thicker than the first clad layer 121b.

The first clad layer 121b is made of a material more resistant to corrosion than the first conductive layer 121a, and thus has a technical effect of minimizing a short circuit defect caused by migration between the first conductive layer 121a of the first assembly wiring 121 and the second conductive layer 122a of the second assembly wiring 122 during the manufacturing of the display device 100. For example, the first clad layer 121b may be made of molybdenum (Mo), molybdenum titanium (MoTi), etc., but is not limited thereto.

The plurality of second assembly wirings 122 may include a second conductive layer 122a and a second clad layer 122b. The second conductive layer 122a may be disposed to be spaced apart from the first conductive layer 121a on the second passivation layer 115. The second clad layer 122b may be in contact with the second conductive layer 122a. For example, the second clad layer 122b may be disposed to cover the upper surface and side surfaces of the second conductive layer 122a. In addition, the second conductive layer 122a may have a thickness that is thicker than the second clad layer 122b. At this time, the first conductive layer 121a of the first assembly wiring 121 may include the same material as the first conductive layer 122a of the second assembly wiring 122, and the clad layer 121b of the first assembly wiring 121 and the clad layer 122b of the second assembly wiring 122 may include the same material.

In the past, the first assembly wiring and the second assembly wiring were used as assembly electrodes to self-assemble the light emitting device, and at this time, the first assembly wiring and the second assembly wiring were each formed using an exposure process. However, in the case of the exposure process, the first assembly wiring and the second assembly wiring had to be disposed at a certain distance or more due to the overlay margin of the exposure device, and accordingly, due to the limitation of the separation distance, the gap between the first assembly wiring and the second assembly wiring widened, and the size of the opening where the light emitting device is disposed became larger. For example, when the first assembly wiring and the second assembly wiring are disposed on different layers with different metals, the limitation of the separation distance is about 6 µm, and when the first assembly wiring and the second assembly wiring are disposed on the same layer with the same metal, the limitation of the separation distance occurred at about 8 µm. Therefore, when self-assembling a light emitting device using the first assembly wiring and the second assembly wiring, the size of the opening where the light emitting device is placed increases due to the distance between the first assembly wiring and the second assembly wiring, so there was a problem that the light emitting device was detached or did not make contact with the assembly electrode.

Accordingly, in the display device 100 according to the embodiment, the distance between the first assembly wiring 121 and the second assembly wiring 122 may be narrowed by adding a structure 125 that is in contact with the second assembly wiring 122 and has a reverse taper shape.

Specifically, in order to narrow the distance between the first assembly wiring 121 and the second assembly wiring 122 according to the embodiment, the conductive layer 121a of the first assembly wiring 121 and the conductive layer 122a of the second assembly wiring 122 are disposed on the same layer and spaced apart from each other. Then, the structure 125 may be disposed to cover a part of the upper surface of the second conductive layer 122a of the second assembly wiring 122. The structure 125 may be made of an inorganic material or an organic material, and may include, for example, silicon oxide (SiOx) or silicon nitride (SiNx), but is not limited thereto. At this time, a first conductive layer 121a of a first assembly wiring 121 may be disposed on one side of the structure 125, and a second conductive layer 122a of a second assembly wiring 122 may be disposed on the other side.

Next, one clad layer may be deposited to cover all of the first conductive layer 121a, the second conductive layer 122a, and the structure 125. At this time, since the width of the upper cross-section of the structure 125 covering a part of the upper surface of the second conductive layer 122a is wider than the width of the lower cross-section, the one clad layer may be separated into a first clad layer 121b covering the upper surface and side surface of the first conductive layer 121a on one side of the structure 125 and a second clad layer 122b covering the upper surface and side surface of the structure 125 covering the upper surface and side surface of the second conductive layer 122a on the other side of the structure 125 and a part of the upper surface of the second conductive layer 122a. Accordingly, regardless of the overlay margin of the exposure device, the first assembly wiring 121 and the second assembly wiring 122 are separated from the structure 125 having a reverse taper shape, so that the separation distance between the first assembly wiring 121 and the second assembly wiring 122 may be reduced, and the size of the first opening 117a may be reduced.

In addition, a second layer (VDD2) of the high-potential power wiring (VDD) may be disposed on the second passivation layer 115. The second layer (VDD2) may extend in the column direction between each of the plurality of sub-pixels (SP) and may overlap the first layer (VDD1). The first layer (VDD1) and the second layer (VDD2) may be electrically connected through a contact hole formed in the insulating layers formed between the first layer (VDD1) and the second layer (VDD2). The second layer (VDD2) may be formed of the same material and through the same process as the first assembly wiring 121 and the second assembly wiring 122, but is not limited thereto.

A connection electrode (CE) may be disposed on each of a plurality of sub-pixels (SP). The connection electrode (CE) is electrically connected to a second capacitor electrode (ST2) and a second source electrode (SE2) of a second transistor (TR2) through a contact hole formed in a second passivation layer 115. The connection electrode (CE) is an electrode for electrically connecting a light emitting device (LED) and a second transistor (TR2) which is a driving transistor, and includes a first connection layer (CE1) and a second connection layer (CE2). For example, the first connection layer (CE1) may be formed of the same material as the first conductive layer 121a of the first assembly wiring 121 and the second conductive layer 122a of the second assembly wiring 122 in the same layer, and the second connection layer (CE2) may be formed of the same material as the first clad layer 121b and the second clad layer 122b in the same layer.

Next, a planarization layer 117 may be placed on the first assembly wiring 121 and the second assembly wiring 122. The planarization layer 117 may be configured as a single layer or multiple layers, and for example, for convenience of the process, the planarization layer 117 may be configured as a multiple layer including a first planarization layer 117-1 and a second planarization layer 117-2 on the first planarization layer 117-1. The planarization layer 117 may be made of an acrylic-based organic material, but is not limited thereto.

Meanwhile, the planarization layer 117 may include a plurality of first openings 117a in which each of a plurality of light emitting devices (LEDs) is mounted, and a plurality of second openings 117b that expose each of a plurality of connection electrodes (CEs).

A plurality of first openings 117a may be disposed in each of the plurality of sub-pixels (SP). At this time, one or more first openings 117a may be disposed in one sub-pixel (SP). For example, one first opening 117a may be disposed in one sub-pixel (SP), or two first openings 117a may be disposed.

The plurality of first openings 117a are portions into which a plurality of light emitting devices (LEDs) are inserted, and may also be referred to as pockets. The plurality of first openings 117a may be formed to overlap a plurality of assembly wirings 120. For example, one first opening 117a may overlap a first assembly wiring 121 and a second assembly wiring 122 that are disposed adjacent to each other in one sub-pixel (SP). The area where the second assembly wiring 122 and the first opening 117a overlap may be wider than the area where the first assembly wiring 121 and the first opening 117a overlap.

A plurality of second openings 117b may be disposed in a plurality of sub-pixels (SP). The plurality of second openings 117b are portions that expose the connection electrodes (CE) of each of the plurality of sub-pixels (SP). The connection electrodes (CE) under the second planarization layer 117 are exposed in the plurality of second openings 117b, and may be electrically connected to the light emitting device (LED), and may transmit the driving current from the second transistor (TR2) to the light emitting device (LED). At this time, the third passivation layer 116 may have a contact hole in an area overlapping the second openings 117b, and the connection electrodes (CE) may be exposed from the second planarization layer 117 and the third passivation layer 116.

Meanwhile, a third passivation layer 116 may be further included between the first assembly wiring 121 and the light emitting device (LED) inserted into the first opening 117a. At this time, the second assembly wiring 122 may be exposed from the third passivation layer 116 in the opening 117a. The third passivation layer 116 is an insulating layer for protecting the configuration under the third passivation layer 116, and may also be referred to as an insulating layer. The third passivation layer 116 may be composed of a single layer or multiple layers of silicon oxide (SiOx) or silicon nitride (SiNx), but is not limited thereto.

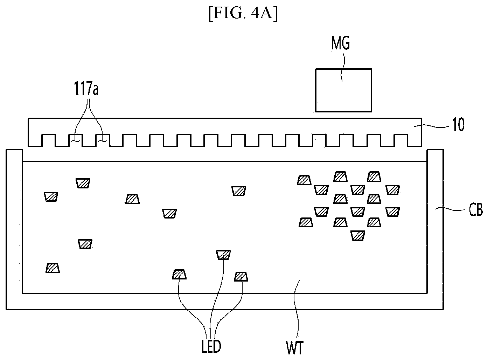

In addition, the third passivation layer 116 is disposed to cover the first assembly wiring 121 and is not disposed on the second assembly wiring 122, so as to offset the step difference between the first assembly wiring 121 and the second assembly wiring 122 caused by the structure 125. That is, the upper surface of the third passivation layer 166 may be disposed on the same plane as the upper surface of the second assembly wiring 122, and accordingly, the lower portion of the first opening 117a where the light emitting device (LED) is disposed becomes flat, so that the assembly of the light emitting device (LED) may be more advantageous. In addition, the third passivation layer 116 may function as an insulating layer to prevent a short circuit defect due to migration between the first assembly wiring 121 and the second assembly wiring 122 during the manufacturing of the display device 100 which will be described later with reference to FIGS. 4A to 4F.

A plurality of light emitting devices (LEDs) may be disposed in a plurality of first openings 117a of the planarization layer 117. The plurality of light emitting devices (LEDs) are light emitting devices (LEDs) that emit light by current. The plurality of light emitting devices (LEDs) may include light emitting devices (LEDs) that emit red light, green light, blue light, etc., and a combination of these may implement various colors of light including white. For example, the light emitting devices (LEDs) may be, but are not limited to, LEDs (Light Emitting Diodes) or micro LEDs.

Hereinafter, it will be described assuming that the plurality of light emitting devices (LEDs) include a red light emitting device 130 disposed in a red sub-pixel (SPR), a green light emitting device 140 disposed in a green sub-pixel (SPG), and a blue light emitting device 150 disposed in a blue sub-pixel (SPB). However, the plurality of light emitting devices (LEDs) are composed of light emitting devices (LEDs) that emit light of the same color, and images of various colors may be displayed by using a separate light conversion member that converts light from the plurality of light emitting devices (LEDs) into light of a different color, but is not limited thereto.

The plurality of light emitting devices (LEDs) include a red light emitting device 130 disposed in a red sub-pixel (SPR), a green light emitting device 140 disposed in a green sub-pixel (SPG), and a blue light emitting device 150 disposed in a blue sub-pixel (SPB). Each of the red-light emitting device 130, the green light emitting device 140, and the blue light emitting device 150 may include a first semiconductor layer, a second semiconductor layer, a first electrode, and a second electrode in common. In addition, the red-light emitting device 130 may include a light emitting layer that emits red light, the green light emitting device 140 may include a light emitting layer that emits green light, and the blue light emitting device 150 may include a light emitting layer that emits blue light. For convenience of explanation, the following description will be made by exemplifying a case where the light emitting device (LED) is a red light emitting device 130 disposed in a red sub-pixel (SPR), but is not limited thereto.

Referring to FIG. 3, a second semiconductor layer 133 may be disposed on a first semiconductor layer 217 in a red-light emitting device 130 disposed in a red sub-pixel (SPR). The first semiconductor layer 217 and the second semiconductor layer 133 may be layers formed by doping a specific material with n-type and p-type impurities. For example, the first semiconductor layer 217 and the second semiconductor layer 133 may include an AlInGaP-based semiconductor layer, and may be a layer in which a p-type or n-type impurity is doped in a material such as indium aluminum phosphide (InAlP), gallium arsenide (GaAs), or the like. In addition, the p-type impurity may be magnesium (Mg), zinc (Zn), beryllium (Be), or the like, and the n-type impurity may be silicon (Si), germanium (Ge), tin (Sn), or the like, but is not limited thereto.

A light emitting layer 132 that emits red light may be placed between the first semiconductor layer 217 and the second semiconductor layer 133. The light emitting layer 132 may receive holes and electrons from the first semiconductor layer 217 and the second semiconductor layer 133 to emit light. The light emitting layer 132 may be formed of a single layer or a multi-quantum well (MQW) structure.

The light emitting layer 132 may convert the injected electric energy into light having a specific wavelength within a range of about 570 nm to about 630 nm. The change in the specific wavelength is determined by the size of the band gap of the light-emitting diode, and the size of the band gap may be controlled by changing the composition ratio of Al and Ga. For example, the wavelength becomes shorter as the composition ratio of Al increases.

The first electrode 134 may be placed on the lower surface of the first semiconductor layer 217, and the second electrode 135 may be placed on the upper surface of the second semiconductor layer 133. The first electrode 134 is an electrode bonded to the second assembly wiring 122 exposed in the first opening 117a, and the second electrode 135 is an electrode that electrically connects the pixel electrode (PE) described later and the second semiconductor layer 133. The first electrode 134 and the second electrode 135 may be formed of a conductive material.

At this time, the first electrode 134 may be formed of a eutectic metal in order to bond the first electrode 134 to the second assembly wiring 122. For example, the first electrode 134 may be formed of tin (Sn), indium (In), zinc (Zn), lead (Pb), nickel (Ni), gold (Au), platinum (Pt), copper (Cu), etc., but is not limited thereto.

In addition, both the green light emitting device 140 and the blue light emitting device 150 may be formed with the same structure as the red light emitting device 130. For example, a green light emitting device 140 may be formed of a first electrode, a first semiconductor layer on the first electrode, a green light emitting layer on the first semiconductor layer, a second semiconductor layer on the green light emitting layer, and a second electrode on the second semiconductor layer, and a blue light emitting device may also be formed of a structure in which a first electrode, a first semiconductor layer, a blue light emitting layer, a second semiconductor layer, and a second electrode are sequentially laminated.

Meanwhile, although not shown in the drawing, an insulating layer may be disposed to surround a portion of each of the plurality of light emitting devices 130. Specifically, the insulating layer may cover at least a side surface of the light emitting device 130 among the outer surfaces of the plurality of light emitting devices 130. By forming an insulating layer on the light emitting device 130, the light emitting device 130 may be protected, and electrical shorts between the first semiconductor layer 217 and the second semiconductor layer 133 may be prevented when the first electrode 134 and the second electrode 135 are formed.

Next, an upper planarization layer 118 may be disposed on the plurality of light emitting devices 130. The upper planarization layer 118 may planarize the upper portion of the substrate 110 on which a plurality of light emitting devices 130 are disposed, and the plurality of light emitting devices 130 may be stably fixed in the first opening 117a by the upper planarization layer 118. The upper planarization layer 118 may be composed of a single layer or multiple layers, and may be made of, for example, an acrylic-based organic material, but is not limited thereto.

A pixel electrode (PE) may be disposed on the upper planarization layer 118. The pixel electrode (PE) is an electrode for electrically connecting a plurality of light emitting devices 130 and a connection electrode (CE). The pixel electrode (PE) may be electrically connected to the light emitting device 130 of the first opening 117a and the connection electrode (CE) of the second opening 117b through a contact hole formed in the upper planarization layer 118. Accordingly, the second electrode 135, the connection electrode (CE) and the second transistor (TR2) of the light emitting device 130 may be electrically connected through the pixel electrode (PE).

A third layer (VDD3) of the high-potential power wiring (VDD) may be disposed on the upper planarization layer 118. The third layer (VDD3) may electrically connect the first layer (VDD1) and the second layer (VDD2) disposed in different columns. For example, the third layer (VDD3) may extend in the row direction between the plurality of sub-pixels (SP) and electrically connect the plurality of second layers (VDD2) of high-potential power lines (VDD) extending in the column direction to each other. In addition, since the plurality of high-potential power lines (VDD) are connected in a mesh form through the third layer (VDD3), there is a technical effect that a voltage drop phenomenon may be reduced.

A black matrix (BM) is disposed on the upper planarization layer 118. The black matrix (BM) may be disposed between a plurality of sub-pixels (SP) on the upper planarization layer 118. The black matrix (BM) may reduce color mixing between the plurality of sub-pixels (SP). The black matrix (BM) may be made of an opaque material, for example, black resin, but is not limited thereto.

A protective layer 119 is disposed on the pixel electrode (PE), the upper planarization layer 118, and the black matrix (BM). The protective layer 119 is a layer for protecting a configuration under the protective layer 119, and may be made of a single layer or multiple layers of a light-transmitting epoxy, silicon oxide (SiOx), or silicon nitride (SiNx), but is not limited thereto.

Meanwhile, in the first opening 117a, the plurality of first assembly wirings 121 are spaced apart from the plurality of light emitting devices 130, and only the plurality of second assembly wirings 122 may contact the plurality of light emitting devices 130. In order to prevent a defect that occurs when the plurality of light emitting devices 130 are in contact with both the plurality of first assembly wirings 121 and the plurality of second assembly wirings 122 during the manufacturing process of the display device 100, a third passivation layer 116 is formed on the plurality of first assembly wirings 121, and the plurality of light emitting devices 130 may be contacted only with the plurality of second assembly wirings 122.

Hereinafter, a method for manufacturing a display device 100 according to an embodiment will be described in detail with reference to FIGS. 4A to 4F.

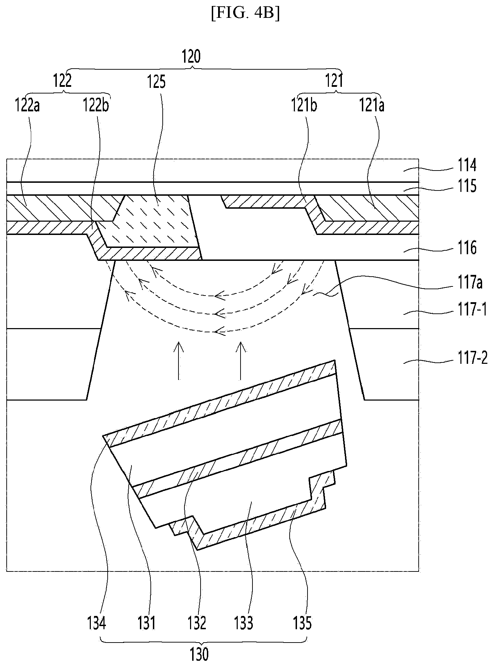

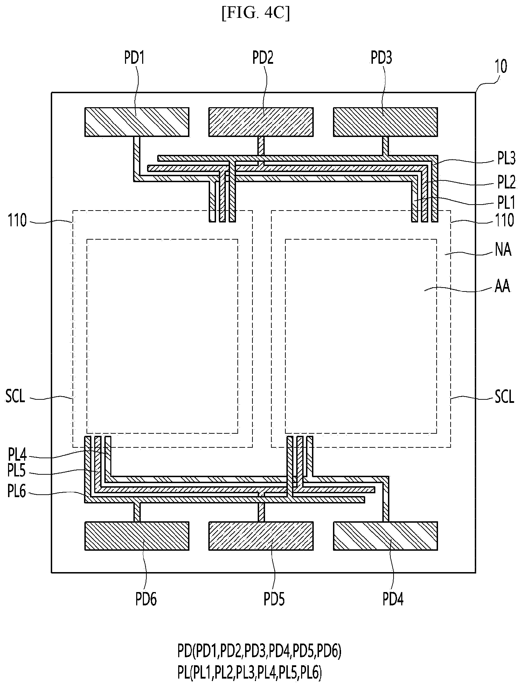

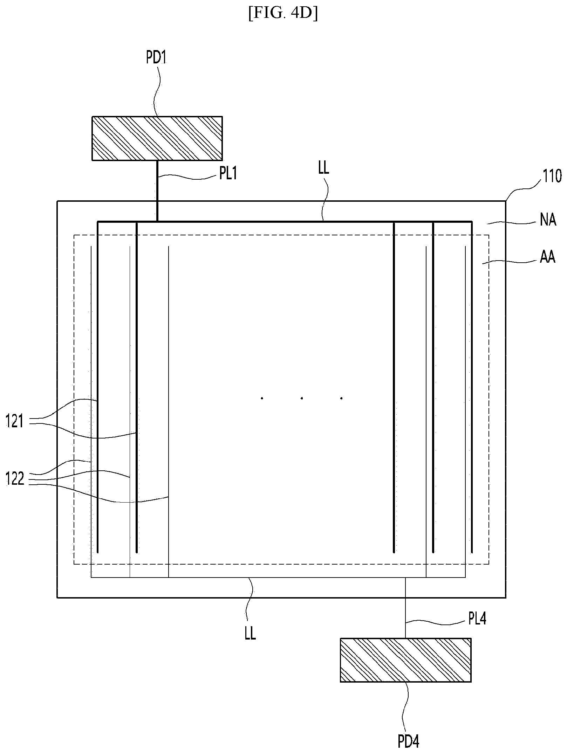

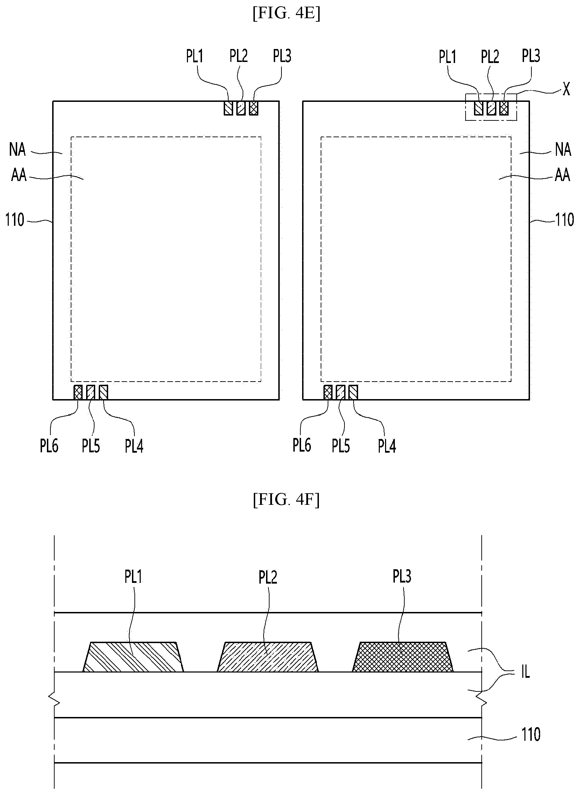

FIGS. 4A to 4F are process diagrams for explaining a method of manufacturing a display device according to an embodiment. FIGS. 4A and 4B are process diagrams for explaining a process of self-assembling a plurality of light emitting devices (LEDs) into a first opening 117a. FIG. 4C is a schematic plan view of a mother substrate 10 used for self-assembly of a plurality of light emitting devices (LEDs). FIG. 4D is a drawing schematically showing an electrical connection relationship between a plurality of assembly wirings 120 and an assembly pad (PD). FIG. 4E is a schematic plan view of a plurality of substrates 110 formed by scribing a mother substrate 10 after self-assembly of a plurality of light emitting devices (LEDs) is completed. FIG. 4F is a schematic cross-sectional view of an area X of FIG. 4E.

Referring to FIG. 4A, a light emitting device (LED) is introduced into a chamber (CB) filled with a fluid (WT). The fluid (WT) may include water, etc., and the chamber (CB) filled with the fluid (WT) may have an open top shape.

Next, the mother substrate 10 may be positioned on the chamber (CB) filled with light emitting devices (LEDs). The mother substrate 10 is a substrate composed of a plurality of substrates 110 that form the display device 100, and when self-assembling a plurality of light emitting devices (LEDs), a mother substrate 10 formed with a plurality of assembly wirings 120 and a planarization layer 117 may be used.

Then, the mother substrate 10 formed with the first assembly wiring 121, the second assembly wiring 122, and the planarization layer 117 is positioned on the chamber (CB) or introduced into the chamber (CB). At this time, the mother substrate 10 may be positioned so that the first opening 117a of the planarization layer 117 and the fluid (WT) face each other.

Next, a magnet (MG) may be positioned on the mother substrate 10. The light emitting devices (LEDs) that sink or float on the bottom of the chamber (CB) may move toward the mother substrate 10 by the magnetic force of the magnet (MG).

At this time, the light emitting devices (LEDs) may include a magnetic material to move by the magnetic field. For example, the first electrode 134 or the second electrode 135 of the light emitting devices (LEDs) may include a ferromagnetic material such as iron, cobalt, or nickel.

Next, the light emitting devices (LEDs) that have moved toward the planarization layer 117 by the magnet (MG) may be self-assembled into the first opening 117a by the electric field formed by the first assembly wiring 121 and the second assembly wiring 122.

An alternating voltage may be applied to the plurality of first assembly wirings 121 and the plurality of second assembly wirings 122 to form an electric field. The light emitting device (LED) may be dielectrically polarized by this electric field to have polarity. In addition, the dielectrically polarized light emitting device (LED) may be moved or fixed in a specific direction by dielectrophoresis (DEP), that is, by the electric field. Therefore, the plurality of light emitting devices (LED) may be fixed in the first opening 117a of the planarization layer 117 by using dielectrophoresis.

Next, the mother substrate 10 may be flipped 180° while the light emitting device (LED) is fixed in the first opening 117a by using the electric fields of the plurality of first assembly wirings 121 and the plurality of second assembly wirings 122. If the mother substrate 10 is turned over without applying voltage to the plurality of first assembly wirings 121 and the plurality of second assembly wirings 122, the plurality of light emitting devices (LEDs) may fall out within the first opening 117a. Therefore, the mother substrate 10 may be turned over while applying voltage to the plurality of first assembly wirings 121 and the plurality of second assembly wirings 122, and subsequent processes may be performed.

Then, while the first electrode 134 of the light emitting device (LED) is positioned on the second assembly wiring 122, heat and pressure may be applied to the light emitting device (LED) to bond the light emitting device (LED) to the second assembly wiring 122. For example, the first electrode 134 of the light emitting device (LED) may be bonded to the second assembly wiring 122 through eutectic bonding. Eutectic bonding is a bonding method using thermal compression at high temperatures, and is one of the bonding processes that is very strong and highly reliable. The eutectic bonding method not only realizes high bonding strength, but also has the advantage of not requiring a separate adhesive to be applied from the outside. However, the bonding method of multiple light emitting devices (LEDs) may be configured in various ways other than eutectic bonding, and is not limited thereto.

Meanwhile, different voltages are applied to the plurality of first assembly wirings 121 and the plurality of second assembly wirings 122 when manufacturing the display device 100, but the same voltage is applied when the display device 100 is driven. To this end, when manufacturing the display device 100, the plurality of first assembly wirings 121 and the plurality of second assembly wirings 122 are connected to different assembly pads (PD), so that different voltages may be applied.

In this regard, referring to FIG. 4C, when manufacturing a display device 100, in the state of a mother substrate 10, assembly wiring 120 on a plurality of substrates 110 may be connected to assembly pads (PD) on the outside of a plurality of substrates 110. Specifically, a plurality of assembly pads (PD) and a plurality of assembly wiring connection parts (PL) may be disposed on a mother substrate 10 together with a plurality of substrates 110 forming a display device 100.

The plurality of assembly pads (PD) are pads for applying voltage to the plurality of assembly wirings 120 and may be electrically connected to a plurality of assembly wirings 120 disposed on each of the plurality of substrates 110 forming the mother substrate 10. A plurality of assembly pads (PD) may be formed on the outer side of the substrate 110 of the display device 100 on the main substrate 10, and may be separated from the substrate 110 of the display device 100 when the manufacturing process of the display device 100 is completed. For example, when two substrates 110 are formed on the main substrate 10, a plurality of first assembly wirings 121 disposed on each substrate 110 may be connected to one assembly pad (PD), and a plurality of second assembly wirings 122 may be connected to another assembly pad (PD).

Therefore, after positioning the mother substrate 10 in the chamber (CB) in which a plurality of light emitting devices (LEDs) are inserted, an AC voltage may be applied to a plurality of assembly wirings 120 through a plurality of assembly pads (PD) to form an electric field, and the plurality of light emitting devices (LEDs) may be easily self-assembled into the first opening 117a of the planarization layer 117.

Meanwhile, in the case of self-assembling a plurality of light emitting devices (LEDs) for each of a plurality of sub-pixels (SP), a plurality of assembly wirings 120 disposed in a plurality of red sub-pixels (SPR), a plurality of assembly wirings 120 disposed in a plurality of green sub-pixels (SPG), and a plurality of assembly wirings 120 disposed in a plurality of blue sub-pixels (SPB) may be connected to different assembly pads (PD).

In this case, the plurality of assembly pads (PD) may include a first assembly pad (PD1), a second assembly pad (PD2), a third assembly pad (PD3), a fourth assembly pad (PD4), a fifth assembly pad (PD5), and a sixth assembly pad (PD6).

The first assembly pad (PD1) is a pad for applying voltage to a plurality of first assembly wirings 121 disposed in a plurality of red sub-pixels (SPR) on the mother substrate 10. The fourth assembly pad (PD4) is a pad for applying voltage to a plurality of second assembly wirings 122 disposed in a plurality of red sub-pixels (SPR) on the mother substrate 10.

The second assembly pad (PD2) is a pad for applying voltage to a plurality of first assembly wirings 121 disposed in a plurality of green sub-pixels (SPG) on the mother substrate 10. The fifth assembly pad (PD5) is a pad for applying voltage to a plurality of second assembly wirings 122 disposed in a plurality of green sub-pixels (SPG) on the mother substrate 10.

The third assembly pad (PD3) is a pad for applying voltage to a plurality of first assembly wirings 121 disposed in a plurality of blue sub-pixels (SPBs) on the mother substrate 10. The sixth assembly pad (PD6) is a pad for applying voltage to a plurality of second assembly wirings 122 disposed in a plurality of blue sub-pixels (SPBs) on the mother substrate 10.

Through these multiple assembly pads (PD), light emitting devices (LEDs) may be selectively self-assembled only to specific sub-pixels (SPs) among multiple sub-pixels (SPs). For example, when self-assembling light emitting devices (LEDs) only to multiple red sub-pixels (SPRs), voltage may be applied only to multiple first assembly wirings 121 and multiple second assembly wirings 122 disposed in multiple red sub-pixels (SPRs) through the first assembly pad (PD1) and the fourth assembly pad (PD4).

The assembly wiring connection part (PL) is a wire that connects multiple assembly wirings 120 on each substrate 110 and multiple assembly pads (PDs). One end of the assembly wiring connection part (PL) is connected to multiple assembly pads (PDs), and the other end extends onto multiple substrates 110 to be electrically connected to multiple first assembly wirings 121 and multiple second assembly wirings 122. The assembly wiring connector (PL) includes a first connector (PL1), a second connector (PL2), a third connector (PL3), a fourth connector (PL4), a fifth connector (PL5), and a sixth connector (PL6).

The first connecting portion (PL1) is a wiring that electrically connects the first assembly wiring 121 disposed in the plurality of red sub-pixels (SPR) on the mother substrate 10 and the first assembly pad (PD1). The fourth connecting portion (PL4) is a wiring that electrically connects the second assembly wiring 122 disposed in the plurality of red sub-pixels (SPR) on the mother substrate 10 and the fourth assembly pad (PD4). For example, the first connecting portion (PL1) may be electrically connected to the plurality of first assembly wirings 121 disposed in the red sub-pixels (SPR) of each of the plurality of substrates 110 by extending the other end to each of the plurality of substrates 110. For example, the fourth connecting portion (PL4) may be electrically connected to the plurality of second assembly wirings 122 disposed in the red sub-pixels (SPR) of each of the plurality of substrates 110 by extending the other end to each of the plurality of substrates 110.

The second connection part (PL2) is a wiring that electrically connects the first assembly wiring 121 disposed on a plurality of green sub-pixels (SPG) on the mother substrate 10 and the second assembly pad (PD2). The fifth connection part (PL5) is a wiring that electrically connects the second assembly wiring 122 disposed on a plurality of green sub-pixels (SPG) on the mother substrate 10 and the fifth assembly pad (PD5).

The third connection part (PL3) is a wiring that electrically connects the first assembly wiring 121 disposed on a plurality of blue sub-pixels (SPBs) on the mother substrate 10 and the third assembly pad (PD3). The sixth connection part (PL6) is a wiring that electrically connects the second assembly wiring 122 disposed on a plurality of blue sub-pixels (SPBs) on the mother substrate 10 and the sixth assembly pad (PD6).

At this time, the plurality of first assembly wirings 121 disposed on one substrate 110 are connected as one, and the plurality of second assembly wirings 122 are also connected as one, so that the plurality of first assembly wirings 121 and the plurality of second assembly wirings 122 may be easily connected to the assembly wiring connection part (PL).

For example, referring to FIG. 4D, first assembly wirings 121 disposed in a plurality of red sub-pixels (SPR) on one substrate 110 may be connected as one through link wirings (LL) in a non-display area (NA) of the substrate 110, and second assembly wirings 122 disposed in a plurality of red sub-pixels (SPR) may also be connected as one through link wirings (LL) in a non-display area (NA) of the substrate 110. In this case, instead of individually connecting each of the plurality of first assembly wirings 121 and the plurality of second assembly wirings 122 disposed on one substrate 110 to the assembly wiring connection part (PL), the link wiring (LL) connecting each of the plurality of first assembly wirings 121 and the plurality of second assembly wirings 122 to one in the non-display area (NA) is connected to the assembly wiring connection part (PL), so that a voltage for self-assembly of the light emitting device (LED) may be easily applied to the plurality of first assembly wirings 121 and the plurality of second assembly wirings 122.

Meanwhile, the assembly wiring connection part (PL) may be formed of the same material and the same process as the plurality of assembly wirings 120, or may be formed of different materials and processes. In addition, the assembly wiring connection part (PL) may have a single-layer structure or a multi-layer structure, but is not limited thereto.

In addition, the assembly wiring connection part (PL) and the assembly pad (PD) illustrated in FIG. 4C and FIG. 4D are exemplary, and may vary depending on the arrangement and shape of the assembly wiring connection part (PL) and the assembly pad (PD), the number of times or order of the self-assembly process, and the design of the plurality of sub-pixels (SP).

Next, referring to FIG. 4E and FIG. 4F, after the self-assembly process of the plurality of light emitting devices (LEDs) is completed, the mother substrate 10 may be cut along the scribing line (SCL) to separate into a plurality of substrates 110. In addition, when scribing the mother substrate 10, a part of the assembly wiring connection part (PL) connecting the plurality of assembly wirings 120 and the plurality of assembly pads (PD) at the edge of the substrate 110 may be cut. Accordingly, the cut surface of the assembly wiring connection part (PL) may be confirmed on the cut surface of the substrate 110.

For example, in the X region of FIG. 4E, a cross-section of a substrate 110, a cross-section of a plurality of insulating layers (IL) disposed to form a driving circuit or a plurality of wires on the substrate 110, and a cross-section of an assembly wiring connection part (PL) disposed between a plurality of insulating layers (IL) may be confirmed. A cross-section of a first connection part (PL1) connecting a first assembly wiring part 121 of a plurality of red sub-pixels (SPR) between a plurality of insulating layers (IL), a second connection part (PL2) connecting a first assembly wiring part 121 of a plurality of green sub-pixels (SPG), and a third connection part (PL3) connecting a first assembly wiring part 121 of a plurality of blue sub-pixels (SPB) may be confirmed.

Meanwhile, after the mother substrate 10 is scribed and separated into a plurality of substrates 110, the same voltage may be easily applied to the plurality of first assembly wirings 121 and the plurality of second assembly wirings 122 through the link wire (LL) that connects the plurality of first assembly wirings 121 into one and the link wire (LL) that connects the plurality of second assembly wirings 122 into one. For example, when the display device 100 is driven, voltage may be applied to the plurality of first assembly wirings 121 and the plurality of second assembly wirings 122 by connecting the drive IC to the link wire (LL) that connects each of the plurality of first assembly wirings 121 and the plurality of second assembly wirings 122 into one in the non-display area (NA).

In the display device 100 according to the embodiment, at least some of the plurality of assembly wirings 120 for self-assembly of the plurality of light emitting devices (LEDs) may be utilized as wires for applying a low-potential power voltage to the plurality of light emitting devices (LEDs). When manufacturing the display device 100, a magnetic field may be used to move the plurality of light emitting devices (LEDs) floating in a fluid (WT) adjacent to the mother substrate 10. Then, different voltages may be applied to the plurality of first assembly wirings 121 and the plurality of second assembly wirings 122 to form an electric field, and the plurality of light emitting devices (LEDs) may be self-assembled within the plurality of first openings 117a by the electric field. At this time, instead of forming a separate wire for supplying a low voltage and connecting it to a plurality of self-assembled light emitting devices (LEDs), a first electrode 134 of a light emitting device (LED) is bonded to a second assembly wiring 122 partially exposed within the first opening 117a, so that when the display device 100 is driven, the plurality of assembly wirings 120 may be used as wires for supplying a low voltage to the plurality of light emitting devices (LEDs).

Therefore, in the display device 100 according to the embodiment, there is a technical effect that the plurality of assembly wirings 120 may be used not only as self-assembly of the plurality of light emitting devices (LEDs) but also as wiring for driving the plurality of light emitting devices (LEDs).

In the display device 100 according to the embodiment, the plurality of assembly wirings 120 may reduce corrosion or short-circuit defects of the plurality of assembly wirings 120 by including a clad layer. The plurality of first assembly wirings 121 are formed of a first conductive layer 121a and a first clad layer 121b that surrounds the first conductive layer 121a and is more resistant to corrosion than the first conductive layer 121a, and the plurality of second assembly wirings 122 are formed of a second conductive layer 122a and a second clad layer 122b that surrounds the second conductive layer 122a and is more resistant to corrosion than the second conductive layer 122a. When manufacturing a display device 100, a plurality of light emitting devices (LEDs) may be self-assembled by positioning a base substrate 10 on which a plurality of assembly wirings 120 are formed within a fluid (WT).

In this case, the first conductive layer 121a and/or the second conductive layer 122a may be exposed in the fluid (WT) which may cause corrosion of the assembly wiring 120, and a short circuit defect may occur as a result. Therefore, the second conductive layer 122a of the plurality of second assembly wirings 122 may be wrapped with the second passivation layer 115 and the second clad layer 122b, and the first conductive layer 121a of the plurality of first assembly wirings 121 may be wrapped with the third passivation layer 116 and the first clad layer 121b. Accordingly, the plurality of assembly wirings 120 are formed with a structure including the first clad layer 121b and the second clad layer 122b, thereby providing a technical effect of preventing corrosion of the plurality of assembly wirings 120 and improving reliability.

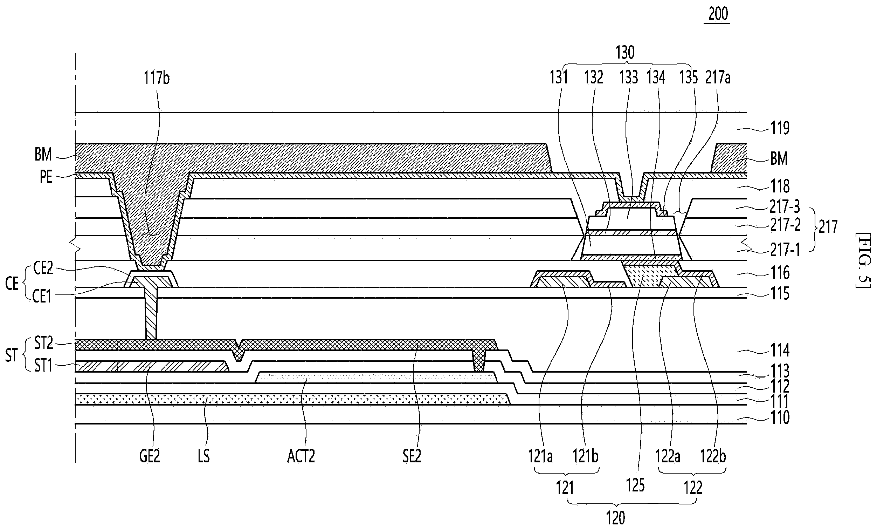

FIG. 5 is a cross-sectional view of a display device according to the second embodiment. The second embodiment of FIG. 5 may adopt the features of the first embodiment. For example, the second embodiment has a technical effect of improving the assembly force of the light emitting device 130 by narrowing the gap between the first assembly wiring 121 and the second assembly wiring 122 by adding a structure 125 that is in contact with the second assembly wiring 122 and has a reverse taper shape. Hereinafter, the planarization layer 217 will be mainly described.

Referring to FIG. 5, the planarization layer 217 may include a first planarization layer 217-1 disposed to surround the side of the light emitting device 130 and having a reverse tapered shape, a second planarization layer 217-2 disposed on the first planarization layer 217-1 to surround the side of the light emitting device 130 and having a regular tapered shape, and a third planarization layer 217-3 disposed on the second planarization layer 217-2 to surround the side of the light emitting device 130 and having a regular tapered shape. At this time, the end of the upper surface of the first planarization layer 217-1 may be in contact with the end of the lower surface of the second planarization layer 217-2, and the end of the upper surface of the second planarization layer 217-2 may be in contact with the end of the lower surface of the third planarization layer 217-3.

When forming an opening in the planarization layer to assemble a light emitting device, a residual film may exist at the lowest part of the planarization layer and may exist in the opening which may increase the assembly defect rate of the light emitting device when the light emitting device is self-assembled. For example, a tilt defect may occur in which the light emitting device is mounted on the planarization layer due to the residual film in the opening.

Accordingly, in the display device (200) according to the second embodiment, the first planarization layer 217-1 disposed at the lowermost end of the planarization layer 217 is formed in a reverse taper shape, thereby preventing the problem of a residual film being generated on the first planarization layer 217-1 and existing in the opening. Accordingly, there is a technical effect of reducing the assembly failure rate due to tilt failure of the light emitting device 130 when the light emitting device 130 is self-assembled within the planarization layer 217.

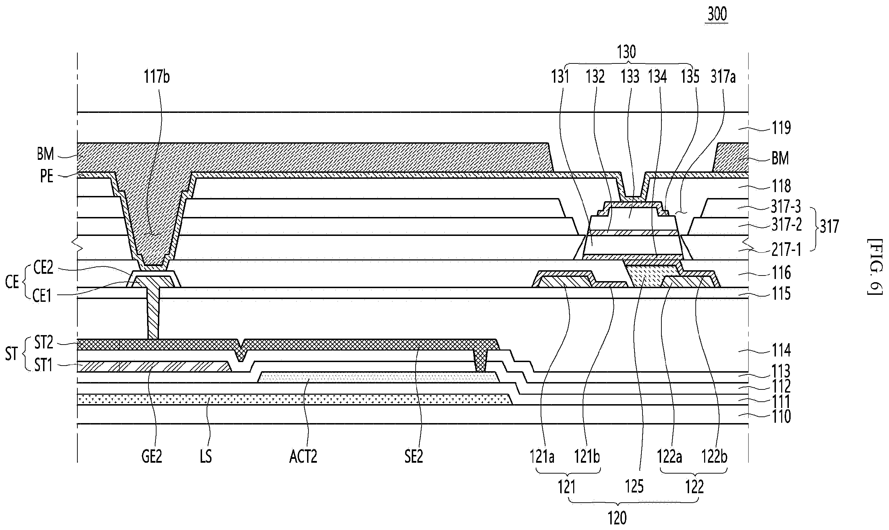

FIG. 6 is a cross-sectional view of a display device according to the third embodiment. The third embodiment of FIG. 6 may adopt the features of the first and second embodiments. For example, the third embodiment has a technical effect of reducing assembly defects due to tilt defects of the light emitting device 130 when the light emitting device 130 is self-assembled into the planarization layer 317 by forming the first planarization layer 217-1 in a reverse taper shape.

Hereinafter, the planarization layer 317 will be mainly described.

Referring to FIG. 6, the end of the upper surface of the first planarization layer 217-1 in the planarization layer 317 may protrude toward the opening 317a more than the end of the lower surface of the second planarization layer 317-2, and the end of the upper surface of the second planarization layer 317-2 may protrude toward the opening 317a more than the end of the lower surface of the third planarization layer 317-3. That is, the first planarization layer 217-1, the second planarization layer 317-2, and the third planarization layer 317-3 are formed in a stepwise manner, and at this time, the area of the first planarization layer 217-1 disposed at the lowest portion of the planarization layer 317 is the largest.

Accordingly, in the display device 300 according to the third embodiment, when the second planarization layer 317-2 and the third planarization layer 317-3 having a tapered shape and an opening 317a penetrating them are formed, even if a residual film is generated due to the second planarization layer 317-2 and the third planarization layer 317-3, this residual film is not disposed at the lowest part of the planarization layer 317, but is disposed only at the end of the upper surface of the step-like structure, that is, the end of the upper surface of the first planarization layer 217-1 that protrudes toward the opening 317a more than the end of the lower surface of the second planarization layer 317-2, and the end of the upper surface of the second planarization layer 317-2 that protrudes toward the opening 317a more than the end of the lower surface of the third planarization layer 317-3, so that there is a technical effect that may prevent the problem of the residual film existing within the opening.

Therefore, in the display device 300 according to the third embodiment, there is a technical effect that may further reduce the assembly failure rate due to tilt failure of the light emitting device 130 when the light emitting device 130 is self-assembled in the planarization layer 317.

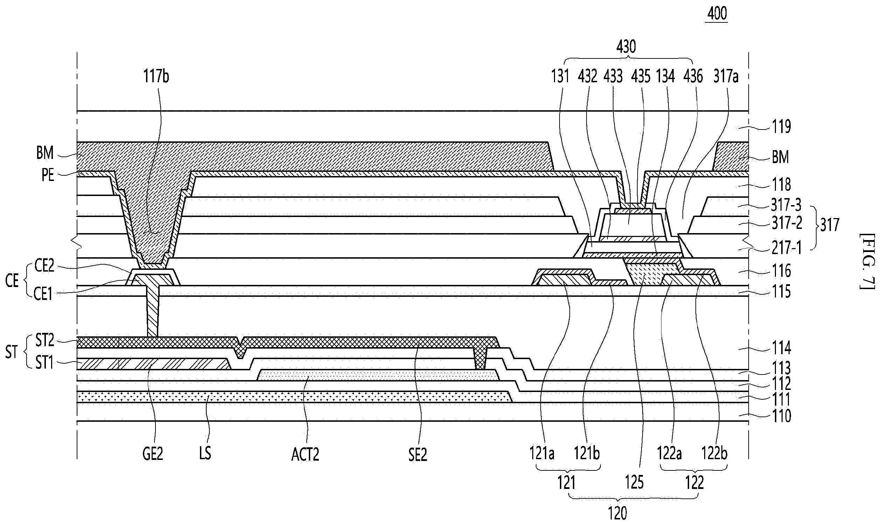

FIG. 7 is a cross-sectional view of the display device according to the fourth embodiment. The fourth embodiment may adopt the features of the first to third embodiments. Hereinafter, the light emitting device 430 will be mainly described.

Referring to FIG. 7, the light emitting device 430 includes a first electrode 134, a first semiconductor layer 217 on the first electrode 134, a light emitting layer 432 on the first semiconductor layer 217, a second semiconductor layer 433 on the light emitting layer 432, a second electrode 435 on the second semiconductor layer 433, and a protective film 436 surrounding a portion of the first semiconductor layer 217, the light emitting layer 432, the second semiconductor layer 433, and the second electrode 435, and the light emitting device 430 has a lower surface having a larger area than the upper surface. That is, the first electrode 134 and the first semiconductor layer 217 may have a larger area than the light emitting layer 432, the second semiconductor layer 433, and the second electrode 435, and the end of the first semiconductor layer 217 may protrude outwardly from the side surface of the light emitting layer 432, the second semiconductor layer 433, and the second electrode 435. At this time, the sum of the thicknesses of the first electrode 134 and the first semiconductor layer 217 may be smaller than the thickness of the first planarization layer 217-1.

In the past, when self-assembling a light emitting device into an opening of a planarization layer, there was a problem in that the light emitting device was detached from the opening due to problems such as the spacing between the first assembly wiring and the second assembly wiring, and the size of the opening of the planarization layer increased accordingly.

Accordingly, in the display device 400 according to the fourth embodiment, there is a technical effect that may prevent the light emitting device 430 from being detached from the planarization layer 317 by controlling the shape of the light emitting device 430. Specifically, in the display device 400 according to the fourth embodiment, the shape of the light emitting device 430 may be controlled in the form described above so that the lower surface of the light emitting device 430 and the upper surface of the first semiconductor layer 217 exist on the inner side of the end of the upper surface of the first planarization layer 217-1.

For example, as described above, the light emitting device 430 may be moved toward the planarization layer 317 by the magnet (MG) and then self-assembled within the first opening 317a by the electric field formed by the first assembly wiring 121 and the second assembly wiring 122. That is, since the light emitting device 430 is self-assembled by an external force such as an electric field, when self-assembling, even if the width of the lower surface of the light emitting device 430 and the upper surface of the first semiconductor layer 217 is wider than the cross-sectional width of the opening 317a of the first planarization layer 217-1, the light emitting device 430 may be self-assembled within the opening 317a of the planarization layer 317 by an external force.

Meanwhile, after self-assembly, when no external force is applied, the light emitting device 430 placed in the opening 317a of the planarization layer 317 has a lower surface of the light emitting device 430 caught by the first planarization layer 217-1 having a narrower cross-sectional width than the width of the lower surface of the light emitting device 430 and the upper surface of the first semiconductor layer 217, so there is a technical effect of preventing detachment from the planarization layer 317.

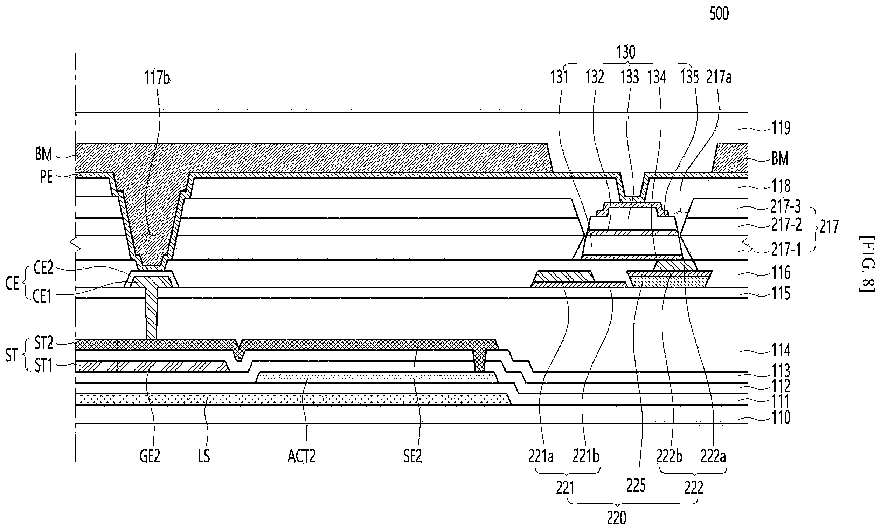

Next, FIG. 8 is a cross-sectional view of a display device according to the fifth embodiment. The fifth embodiment may adopt the features of the second embodiment. For example, by forming the first planarization layer 217-1 in a reverse taper shape, there is a technical effect of reducing the assembly failure rate due to tilt failure of the light emitting device 130 when the light emitting device 130 is self-assembled within the planarization layer 217. Hereinafter, the first assembly wiring and the second assembly wiring will be mainly described.

Referring to FIG. 8, the first assembly wiring 221 and the second assembly wiring 222 may be disposed on the second passivation layer 115. At this time, a structure 225 having a reverse taper shape may be disposed between the second assembly wiring 222 and the second passivation layer 115. The occurrence of a short circuit between the first assembly wiring 221 and the second assembly wiring 222 may be prevented by the reverse taper-shaped structure 225, and there is a technical effect of strengthening the DEP force by narrowing the distance between the two assembly wirings.

And, the second conductive layer 222a of the second assembly wiring 222 may be disposed on the second clad layer 222b and may be disposed to be in contact with the first electrode 134 of the light emitting device 130. Accordingly, the second clad layer 222b may be disposed on the structure 225 and may narrow the distance between it and the first clad layer 222b of the first assembly wiring 221. Accordingly, there is a technical effect that the electric field formed by the first assembly wiring 221 and the second assembly wiring 221 may be strengthened, thereby improving the assembly force of the light emitting device 130.

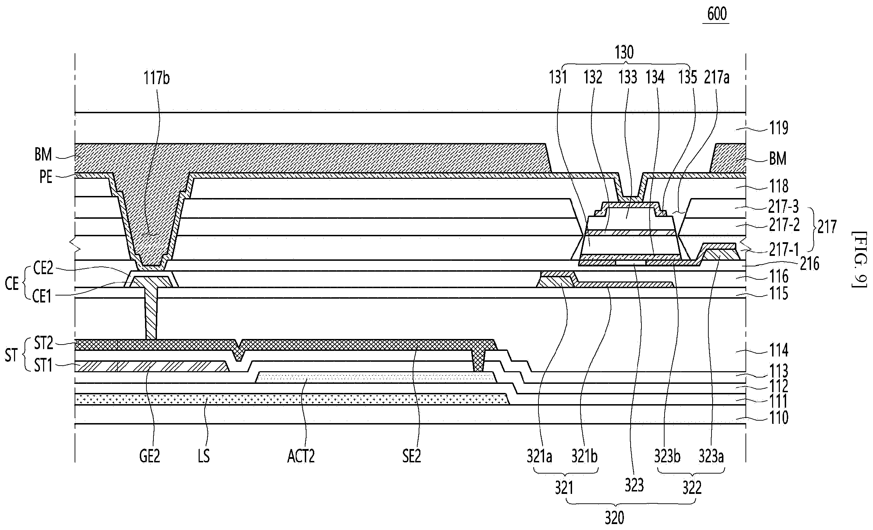

FIG. 9 is a cross-sectional view of a display device according to the sixth embodiment. The sixth embodiment may adopt the features of the second embodiment. For example, by forming the first planarization layer 217-1 in a reverse taper shape, there is a technical effect that may reduce the assembly failure rate due to tilt failure of the light emitting device 130 when the light emitting device 130 is self-assembled within the planarization layer 217. Hereinafter, the first assembly wiring 321 and the second assembly wiring 322 will be mainly described.

Referring to FIG. 9, the first assembly wiring 321 may be disposed on the second passivation layer 115. The first clad layer 321b of the first assembly wiring 321 may be disposed to extend from the upper surface of the first conductive layer (321a) to the inside of the first opening 217a. Additionally, a third passivation layer 116 may be disposed on the second passivation layer 115, and a fourth passivation layer (216) may be disposed on the third passivation layer 116.

At this time, the second assembly wiring 322 may be disposed on the fourth passivation layer (216). The second conductive layer 322a of the second assembly wiring 322 is disposed within the first planarization layer 217-1, and the second clad layer 322b may be disposed to extend from the upper surface of the second conductive layer 322a to the inside of the first opening 217a, and may be disposed to be in contact with the first electrode 134 of the light emitting device 130.

In the sixth embodiment, the first clad layer 321b and the second clad layer 322b may be disposed with the fourth passivation layer 216 interposed therebetween, and may overlap each other from top to bottom. Meanwhile, the second clad layer 322b may be provided with a predetermined electrode hole 323 in an area overlapping the light emitting device 130 and the first clad layer 321b. An electric field is formed by an AC voltage applied to the first clad layer 321b and the second clad layer 322b, and the DEP force by this electric field may be concentrated in the electrode hole 323 provided in the second clad layer 322b. The light emitting device 130 may be self-assembled within the first opening 217a by the concentrated dielectrophoretic force (DEP force).

Since the first assembly wiring 321 and the second assembly wiring 322 are vertically overlapped, there is a technical effect of strengthening the assembly force for the light emitting device 130. Meanwhile, the second clad layer 322b may be placed under the light emitting device (LED). In addition, the second clad layer 322b may be in contact with the first electrode 134 of the light emitting device 130.

Therefore, since the second clad layer 322b is disposed on the lower surface of the first electrode 134 of the light emitting device 130, the light emitting device 130 is uniformly supported, and a wide electrical contact area is secured between them, thereby improving carrier injection efficiency, thereby improving light-emitting efficiency and brightness which have a composite technical effect.

The display device including the semiconductor light emitting device according to the embodiment described above has a technical effect that the wiring for self-assembly of the light emitting device may also be utilized as the wiring for driving the light emitting device.

In addition, the embodiment has a technical effect that may precisely control the spacing between a plurality of assembly wirings.

For example, there is a technical effect that may narrow the spacing between a plurality of assembly wirings by arranging a structure having a reverse taper shape under the assembly wirings.

In addition, the embodiment has a technical effect of minimizing the size of the pocket in which the light emitting device is assembled.

In addition, the embodiment has a technical effect of improving tilt defects during self-assembly of the light emitting device by variously changing the shape of the planarization layer including the opening, and preventing the phenomenon of the light emitting device being separated from the opening.

In addition, the embodiment has a technical effect of strengthening the assembly force of the light emitting device by arranging a plurality of assembly wirings in a vertical symmetrical structure.

The above detailed description should not be construed as restrictive in all aspects and should be considered exemplary. The scope of the embodiment should be determined by a reasonable interpretation of the appended claims, and all changes within the equivalent scope of the embodiment are included in the scope of the embodiment.

### [Explanation of reference signs]

10: substrate AA: display area NA: non-display area SP: sub-pixel SPR: red sub-pixel SPG: green sub-pixel SPB: blue sub-pixel 100, 200, 300, 400, 500, 600: display device 110: substrate 111: buffer layer 112: gate insulating layer 113: first passivation layer
114: lower planarization layer 115: second passivation layer 116: third passivation layer 216: fourth passivation layer 117, 217, 317: planarization layer 117-1, 217-1, 317-1: first planarization layer
117-2, 217-2, 217-3: second planarization layer 217-3, 317-3: Third planarization layer
117a, 217a, 317a: First opening 117b: Second opening 118: Upper planarization layer
119: Protective layer 120, 220, 320: Assembly wiring 121, 221, 321: First assembly wiring
121a, 221a, 321a: First conductive layer 121b, 221b, 321b: First clad layer
122, 222, 322: Second assembly wiring 122a, 222a, 322a: Second conductive layer
122b, 222b, 322b: Second clad layer 125, 225: Structure
323: Electrode hole LED: Light emitting device 130: Red light emitting device 131: First semiconductor layer
132, 432: Light emitting layer 133, 433: Second semiconductor layer 134: First electrode
135, 435: Second electrode 436: Protective film 140: Green light emitting device 150: Blue light emitting device
LS: Light-shielding layer SL: Scan line DL: Data line RL: Reference line
VDD: High-potential power line VDD1: First layer VDD2: Second layer VDD3: Third layer
TR1: First transistor ACT1: First active layer GE1: First gate electrode
SE1: First source electrode DE1: First drain electrode TR2: Second transistor
ACT2: Second active layer GE2: Second gate electrode SE2: Second source electrode
DE2: Second drain electrode TR3: Third transistor CT3: Third active layer
GE3: Third gate electrode SE3: Third source electrode DE3: Third drain electrode
ST: Storage capacitor ST1: First capacitor electrode ST2: Second capacitor electrode
CE: Connection electrode CE1: First connection layer CE2: Second connection layer PE: Pixel electrode
BM: Black matrix CB: Chamber WT: Fluid MG: Magnet PD: Assembly pad
PD1: First assembly pad PD2: Second assembly pad PD3: Third assembly pad
PD4: Fourth assembly pad PD5: Fifth assembly pad PD6: Sixth assembly pad
PL: Assembly wiring connection PL1: First connection PL2: Second connection
PL3: Third connection PL4: Fourth connection PL5: Fifth connection PL6: Sixth connection
LL: Link wiring SCL: Scribing line IL: Multiple insulation layers

### [Industrial Applicability]

The embodiment may be adopted in the field of displays that display images or information.

The embodiment may be adopted in the field of displays that display images or information using semiconductor light emitting devices.

The embodiment may be adopted in the field of displays that display images or information using micro-level or nano-level semiconductor light emitting devices.

## Claims

1. A display device including a semiconductor light emitting device comprising:
a substrate; (10)
a first assembly wiring (121, 221, 321) and a second assembly wiring (122, 222, 322) disposed to be spaced apart from each other on the substrate and each comprising a conductive layer (121a, 221a, 321a, 122a, 222a, 322a) and a clad layer (121b, 221b, 321b, 122b, 222b, 322b) on the conductive layer;
a planarization layer (117, 217, 317) disposed on the first assembly wiring and the second assembly wiring and comprising an opening; (117a, 217a, 317a) and
a light emitting device (130) disposed inside the opening, wherein a first electrode (134) thereof overlaps the first assembly wiring and the second assembly wiring, **characterized by** a structure (125, 225) in contact with the second assembly wiring and comprising a reverse taper shape,
wherein the structure is disposed to cover a portion of an upper surface of the conductive layer of the second assembly wiring,
wherein the clad layer of the second assembly wiring is disposed to cover an upper surface of the structure.

2. The display device including the semiconductor light emitting device according to claim 1, further comprising an insulating layer disposed between the first assembly wiring and the light emitting device, and
wherein the second assembly wiring is exposed from the insulating layer at the opening.

3. The display device including the semiconductor light emitting device according to claim 2, wherein an upper surface of the second assembly wiring is disposed on a same plane as an upper surface of the insulating layer.

4. The display device including the semiconductor light emitting device according to any one of claims 1 to 3, wherein the conductive layer of the first assembly wiring and the conductive layer of the second assembly wiring are disposed on a same layer, and
wherein the conductive layer of the first assembly wiring is disposed on one side of the structure, and the conductive layer of the second assembly wiring is disposed on other side.

5. The display device including the semiconductor light emitting device according to claim 4, wherein the clad layer of the second assembly wiring is in contact with a part of a side of the structure corresponding to another side of the structure and the upper surface of the structure.

6. The display device including the semiconductor light emitting device according to claim 4, wherein the clad layer of the first assembly wiring and the clad layer of the second assembly wiring comprise a same material.

7. The display device including the semiconductor light emitting device according to any one of claims 1 to 6, wherein a cross-sectional area of the structure is configured to decrease from the upper surface to a lower surface.

8. The display device including the semiconductor light emitting device according to any one of claims 1 to 7, wherein an area where the second assembly wiring and the opening overlap is wider than an area where the first assembly wiring and the opening overlap.

9. The display device including the semiconductor light emitting device according to any one of claims 1 to 8, wherein the planarization layer comprises a first planarization layer disposed to surround a side of the light emitting device and comprising a reverse tapered shape, a second planarization layer disposed on the first planarization layer to surround the side of the light emitting device and comprising a regular tapered shape, and a third planarization layer disposed on the second planarization layer to surround the side of the light emitting device and comprising the regular tapered shape.

10. The display device including the semiconductor light emitting device according to claim 9, wherein an end of an upper surface of the first planarization layer is in contact with an end of a lower surface of the second planarization layer, and
wherein an end of an upper surface of the second planarization layer is in contact with an end of a lower surface of the third planarization layer

11. The display device including the semiconductor light emitting device according to claim 9, wherein an end of an upper surface of the first planarization layer is configured to protrude toward the opening more than an end of a lower surface of the second planarization layer, and
wherein an end of an upper surface of the second planarization layer is configured to protrude toward the opening more than an end of a lower surface of the third planarization layer.

12. The display device including the semiconductor light emitting device according to claim 9, wherein the light emitting device comprises the first electrode, a first semiconductor layer on the first electrode, a light emitting layer on the first semiconductor layer, a second semiconductor layer on the light emitting layer, and a second electrode on the second semiconductor layer, and
wherein the light emitting device comprises a lower surface comprising a larger area than an upper surface thereof.

13. The display device including the semiconductor light emitting device according to claim 12, wherein the first electrode and the first semiconductor layer comprises larger area than the light emitting layer, the second semiconductor layer and the second electrode.

14. The display device including the semiconductor light emitting device according to claim 13, wherein an end of the first semiconductor layer is configured to protrude outwardly from sides of the light emitting layer, the second semiconductor layer, and the second electrode.

15. The display device including the semiconductor light emitting device according to claim 13, wherein a sum of thickness of the first electrode and the first semiconductor layer is smaller than that of the first planarization layer.

## Patentansprüche

1. Anzeigevorrichtung mit einer Halbleiter-Lichtemissionsvorrichtung, aufweisend:
ein Substrat (10);
eine erste Montageverdrahtung (121, 221, 321) und eine zweite Montageverdrahtung (122, 222, 322), die auf dem Substrat beabstandet voneinander angeordnet sind und jeweils eine leitfähige Schicht (121a, 221a, 321a, 122a, 222a, 322a) sowie eine Ummantelungsschicht (121b, 221b, 321b, 122b, 222b, 322b) auf der leitfähigen Schicht aufweisen;
eine Planarisierungsschicht (117, 217, 317), die auf der ersten Montageverdrahtung und der zweiten Montageverdrahtung angeordnet ist und eine Öffnung (117a, 217a, 317a) aufweist, und
eine Lichtemissionsvorrichtung (130), die innerhalb der Öffnung angeordnet ist, wobei eine erste Elektrode (134) derselben die erste Montageverdrahtung und die zweite Montageverdrahtung überlappt,
**gekennzeichnet durch** eine Struktur (125, 225), die mit der zweiten Montageverdrahtung in Kontakt steht und eine invers konische Form aufweist,
wobei die Struktur derart angeordnet ist, dass sie einen Teil einer oberen Oberfläche der leitfähigen Schicht der zweiten Montageverdrahtung bedeckt,
und wobei die Ummantelungsschicht der zweiten Montageverdrahtung derart angeordnet ist, dass sie eine obere Oberfläche der Struktur bedeckt.

2. Anzeigevorrichtung mit der Halbleiter-Lichtemissionsvorrichtung nach Anspruch 1, ferner mit einer Isolierschicht, die zwischen der ersten Montageverdrahtung und der Lichtemissionsvorrichtung angeordnet ist,
wobei die zweite Montageverdrahtung in der Öffnung aus der Isolierschicht freigelegt ist.

3. Anzeigevorrichtung mit der Halbleiter-Lichtemissionsvorrichtung nach Anspruch 2, wobei eine obere Oberfläche der zweiten Montageverdrahtung in derselben Ebene wie eine obere Oberfläche der Isolierschicht angeordnet ist.

4. Anzeigevorrichtung mit der Halbleiter-Lichtemissionsvorrichtung nach einem der Ansprüche 1 bis 3,
wobei die leitfähige Schicht der ersten Montageverdrahtung und die leitfähige Schicht der zweiten Montageverdrahtung in derselben Schicht angeordnet sind,
und wobei die leitfähige Schicht der ersten Montageverdrahtung auf einer Seite der Struktur angeordnet ist und die leitfähige Schicht der zweiten Montageverdrahtung auf der anderen Seite.

5. Anzeigevorrichtung mit der Halbleiter-Lichtemissionsvorrichtung nach Anspruch 4,
wobei die Ummantelungsschicht der zweiten Montageverdrahtung mit einem Teil einer Seitenfläche der Struktur, die der anderen Seite der Struktur entspricht, sowie mit der oberen Oberfläche der Struktur in Kontakt steht.

6. Anzeigevorrichtung mit der Halbleiter-Lichtemissionsvorrichtung nach Anspruch 4,
wobei die Ummantelungsschicht der ersten Montageverdrahtung und die Ummantelungsschicht der zweiten Montageverdrahtung aus demselben Material bestehen.

7. Anzeigevorrichtung mit der Halbleiter-Lichtemissionsvorrichtung nach einem der Ansprüche 1 bis 6,
wobei eine Querschnittsfläche der Struktur so ausgebildet ist, dass sie sich von der oberen Oberfläche zur unteren Oberfläche hin verkleinert.

8. Anzeigevorrichtung mit der Halbleiter-Lichtemissionsvorrichtung nach einem der Ansprüche 1 bis 7,
wobei ein Bereich, in dem sich die zweite Montageverdrahtung und die Öffnung überlappen, breiter ist als ein Bereich, in dem sich die erste Montageverdrahtung und die Öffnung überlappen.

9. Anzeigevorrichtung mit der Halbleiter-Lichtemissionsvorrichtung nach einem der Ansprüche 1 bis 8, wobei die Planarisierungsschicht eine erste Planarisierungsschicht, die so angeordnet ist, dass sie eine Seitenfläche der Lichtemissionsvorrichtung umgibt und eine invers konische Form aufweist, eine zweite Planarisierungsschicht, die auf der ersten Planarisierungsschicht angeordnet ist, die Seitenfläche der Lichtemissionsvorrichtung umgibt und eine regulär konische Form aufweist, und eine dritte Planarisierungsschicht aufweist, die auf der zweiten Planarisierungsschicht angeordnet ist, die Seitenfläche der Lichtemissionsvorrichtung umgibt und die regulär konische Form aufweist.

10. Anzeigevorrichtung mit der Halbleiter-Lichtemissionsvorrichtung nach Anspruch 9,
wobei ein Ende einer oberen Oberfläche der ersten Planarisierungsschicht mit einem Ende einer unteren Oberfläche der zweiten Planarisierungsschicht in Kontakt steht,
und wobei ein Ende einer oberen Oberfläche der zweiten Planarisierungsschicht mit einem Ende einer unteren Oberfläche der dritten Planarisierungsschicht in Kontakt steht.

11. Anzeigevorrichtung mit der Halbleiter-Lichtemissionsvorrichtung nach Anspruch 9,
wobei ein Ende einer oberen Oberfläche der ersten Planarisierungsschicht so ausgebildet ist, dass es weiter in Richtung der Öffnung vorsteht als ein Ende einer unteren Oberfläche der zweiten Planarisierungsschicht,
und wobei ein Ende einer oberen Oberfläche der zweiten Planarisierungsschicht so ausgebildet ist, dass es weiter in Richtung der Öffnung vorsteht als ein Ende einer unteren Oberfläche der dritten Planarisierungsschicht.

12. Anzeigevorrichtung mit der Halbleiter-Lichtemissionsvorrichtung nach Anspruch 9,
wobei die Lichtemissionsvorrichtung die erste Elektrode, eine erste Halbleiterschicht auf der ersten Elektrode, eine Lichtemissionsschicht auf der ersten Halbleiterschicht, eine zweite Halbleiterschicht auf der Lichtemissionsschicht und eine zweite Elektrode auf der zweiten Halbleiterschicht aufweist,
und wobei die Lichtemissionsvorrichtung eine untere Oberfläche aufweist, die eine größere Fläche als eine obere Oberfläche derselben aufweist.

13. Anzeigevorrichtung mit der Halbleiter-Lichtemissionsvorrichtung nach Anspruch 12, wobei die erste Elektrode und die erste Halbleiterschicht eine größere Fläche als die Lichtemissionsschicht, die zweite Halbleiterschicht und die zweite Elektrode aufweisen.

14. Anzeigevorrichtung mit der Halbleiter-Lichtemissionsvorrichtung nach Anspruch 13, wobei ein Ende der ersten Halbleiterschicht so ausgebildet ist, dass es seitlich über die Lichtemissionsschicht, die zweite Halbleiterschicht und die zweite Elektrode hinaus vorsteht.

15. Anzeigevorrichtung mit der Halbleiter-Lichtemissionsvorrichtung nach Anspruch 13, wobei eine Summe der Dicken der ersten Elektrode und der ersten Halbleiterschicht kleiner ist als die der ersten Planarisierungsschicht.

## Revendications

1. Dispositif d'affichage comprenant un dispositif semi-conducteur émetteur de lumière, comprenant :
un substrat (10) ;
un premier câblage d'assemblage (121, 221, 321) et un second câblage d'assemblage (122, 222, 322) disposés sur le substrat de manière espacée l'un de l'autre et comprenant chacun une couche conductrice (121a, 221a, 321a, 122a, 222a, 322a) et une couche de revêtement (121b, 221b, 321b, 122b, 222b, 322b) sur la couche conductrice ;
une couche de planarisation (117, 217, 317) disposée sur le premier câblage d'assemblage et le second câblage d'assemblage et comprenant une ouverture (117a, 217a, 317a), et
un dispositif émetteur de lumière (130) disposé à l'intérieur de l'ouverture, une première électrode (134) de celui-ci recouvrant le premier câblage d'assemblage et le second câblage d'assemblage,
**caractérisé par** une structure (125, 225) en contact avec le second câblage d'assemblage et présentant une forme à dépouille inverse,
dans laquelle la structure est disposée de manière à recouvrir une partie d'une surface supérieure de la couche conductrice du second câblage d'assemblage,
et dans laquelle la couche de revêtement du second câblage d'assemblage est disposée de manière à recouvrir une surface supérieure de la structure.

2. Dispositif d'affichage comprenant le dispositif semi-conducteur émetteur de lumière selon la revendication 1, comprenant en outre une couche isolante disposée entre le premier câblage d'assemblage et le dispositif émetteur de lumière,
et dans lequel le second câblage d'assemblage est exposé hors de la couche isolante au niveau de l'ouverture.

3. Dispositif d'affichage comprenant le dispositif semi-conducteur émetteur de lumière selon la revendication 2, dans lequel une surface supérieure du second câblage d'assemblage est disposée dans un même plan qu'une surface supérieure de la couche isolante.

4. Dispositif d'affichage comprenant le dispositif semi-conducteur émetteur de lumière selon l'une quelconque des revendications 1 à 3, dans lequel la couche conductrice du premier câblage d'assemblage et la couche conductrice du second câblage d'assemblage sont disposées dans une même couche, et
dans lequel la couche conductrice du premier câblage d'assemblage est disposée d'un côté de la structure, et la couche conductrice du second câblage d'assemblage est disposée de l'autre côté.

5. Dispositif d'affichage comprenant le dispositif semi-conducteur émetteur de lumière selon la revendication 4, dans lequel la couche de revêtement du second câblage d'assemblage est en contact avec une partie d'une surface latérale de la structure correspondant à l'autre côté de la structure, ainsi qu'avec la surface supérieure de la structure.

6. Dispositif d'affichage comprenant le dispositif semi-conducteur émetteur de lumière selon la revendication 4, dans lequel la couche de revêtement du premier câblage d'assemblage et la couche de revêtement du second câblage d'assemblage sont constituées d'un même matériau.

7. Dispositif d'affichage comprenant le dispositif semi-conducteur émetteur de lumière selon l'une quelconque des revendications 1 à 6, dans lequel une aire de section transversale de la structure est configurée pour diminuer d'une surface supérieure vers une surface inférieure.

8. Dispositif d'affichage comprenant le dispositif semi-conducteur émetteur de lumière selon l'une quelconque des revendications 1 à 7, dans lequel une zone dans laquelle le second câblage d'assemblage et l'ouverture se recouvrent est plus large qu'une zone dans laquelle le premier câblage d'assemblage et l'ouverture se recouvrent.

9. Dispositif d'affichage comprenant le dispositif semi-conducteur émetteur de lumière selon l'une quelconque des revendications 1 à 8, dans lequel la couche de planarisation comprend une première couche de planarisation disposée de manière à entourer un côté du dispositif émetteur de lumière et présentant une forme à dépouille inverse, une deuxième couche de planarisation disposée sur la première couche de planarisation, entourant le côté du dispositif émetteur de lumière et présentant une forme à dépouille directe, et une troisième couche de planarisation disposée sur la deuxième couche de planarisation, entourant le côté du dispositif émetteur de lumière et présentant la forme à dépouille directe.

10. Dispositif d'affichage comprenant le dispositif semi-conducteur émetteur de lumière selon la revendication 9, dans lequel une extrémité d'une surface supérieure de la première couche de planarisation est en contact avec une extrémité d'une surface inférieure de la deuxième couche de planarisation, et dans lequel une extrémité d'une surface supérieure de la deuxième couche de planarisation est en contact avec une extrémité d'une surface inférieure de la troisième couche de planarisation.

11. Dispositif d'affichage comprenant le dispositif semi-conducteur émetteur de lumière selon la revendication 9, dans lequel une extrémité d'une surface supérieure de la première couche de planarisation est configurée pour faire saillie vers l'ouverture davantage qu'une extrémité d'une surface inférieure de la deuxième couche de planarisation, et dans lequel une extrémité d'une surface supérieure de la deuxième couche de planarisation est configurée pour faire saillie vers l'ouverture davantage qu'une extrémité d'une surface inférieure de la troisième couche de planarisation.

12. Dispositif d'affichage comprenant le dispositif semi-conducteur émetteur de lumière selon la revendication 9, dans lequel le dispositif émetteur de lumière comprend la première électrode, une première couche semi-conductrice sur la première électrode, une couche émettrice de lumière sur la première couche semi-conductrice, une deuxième couche semi-conductrice sur la couche émettrice de lumière, et une deuxième électrode sur la deuxième couche semi-conductrice, et dans lequel le dispositif émetteur de lumière comprend une surface inférieure présentant une aire plus grande qu'une surface supérieure de celui-ci.

13. Dispositif d'affichage comprenant le dispositif semi-conducteur émetteur de lumière selon la revendication 12, dans lequel la première électrode et la première couche semi-conductrice présentent une aire plus grande que la couche émettrice de lumière, la deuxième couche semi-conductrice et la deuxième électrode.

14. Dispositif d'affichage comprenant le dispositif semi-conducteur émetteur de lumière selon la revendication 13, dans lequel une extrémité de la première couche semi-conductrice est configurée pour faire saillie vers l'extérieur au-delà des côtés de la couche émettrice de lumière, de la deuxième couche semi-conductrice et de la deuxième électrode.

15. Dispositif d'affichage comprenant le dispositif semi-conducteur émetteur de lumière selon la revendication 13, dans lequel une somme des épaisseurs de la première électrode et de la première couche semi-conductrice est inférieure à celle de la première couche de planarisation.
